# NEUE EUROPÄISCHE PATENTSCHRIFT

(11) **EP 1 870 489 B2**
(45) Veröffentlichungstag und Bekanntmachung des Hinweises auf die Entscheidung über den Einspruch: **17.10.2012**
(45) Hinweis auf die Patenterteilung: 18.06.2008
(21) Anmeldenummer: 06008081.9
(22) Anmeldetag: 19.04.2006
(51) Int. Cl.: C23C 14/58, C23C 14/16, C23C 22/34, C23C 22/36

(54) **Verfahren zur Herstellung eines korrosionsgeschützten und hochglänzenden Substrats**
Method to obtain a corrosion-resistant and shiny substrate
Méthode d'obtention d'un substrat brillant et anti-corrosion

(43) Veröffentlichungstag der Anmeldung: 26.12.2007
(73) Patentinhaber: Ropal AG, 6302 Zug (CH)
(72) Erfinder: Koch, Matthias, 59969 Bromskirchen (DE); Wübbeling, Guido, 35066 Frankenberg (DE)
(74) Vertreter: Metten, Karl-Heinz

(56) Entgegenhaltungen:
- EP-A- 0 178 020
- EP-A- 1 455 001
- EP-B1- 1 200 641
- WO-A1-2005/7061761
- DE-A1- 4 317 217
- DE-A1-102004 006 127
- DE-T2- 60 127 921
- US-A- 5 073 403
- US-A1- 2004 020 565
- US-B2- 6 896 970
- OTTO LUNDER: 'Chromate-free-pre-treatment of aluminium for adhesive bonding', Mai 2003
- JUDTH PIETSCHAMNN: 'Industrielle Pulverbeschichtung', 2004 Artikel '2.Auflage,Grundlagen Anwendungen'
- 'Gebrauchsanleitung Alodine 400, Chromfreie Konversionsbehandlung von Leichtmetallen und chromfreie Nachpassivierung von Phosphatschichten', 14 Mai 2004 Artikel 'Henkel Surface Technologies'
- DR.-ING. BIRGER DZUR: 'Grundlagen der Oberflächentechnik - Physikalische Verfahren' HANDOUT FÜR BA-WSW,5.FS September 2009,
- PROF.DR. R.ZENGERLE: 'Mikrosystemtechnik: Technologien & Prozesse', Bd. 4,
- 'Physikalissche Gasphasenabscheidung' Gefunden im Internet: <URL:www.Wikipedia>
- DR. R. REUSCHLING: 'Vakuum-Dünnschichttechnik'
- 'Salzsprühtest' Gefunden im Internet: <URL:www.wikipedia>
- 'DIN 50021' Juni 1998,
- 'ISO 9227:2006' KORROISIONSPRÜFUNGEN IN KÜNSTLICHEN ATMOSPHÄREN SALZSPRÜHNEBELPRÜFUNGEN 2006,

## Beschreibung

Die Erfindung betrifft ein Verfahren zur Herstellung eines korrosionsgeschützten und insbesondere hochglänzenden metallischen oder nicht-metallischen Substrats.

Die optische Veredelung beliebiger Substrate, bei der diesen Substraten ein metallischer Eindruck vermittelt wird, ist seit langem bekannt. Dabei werden unterschiedlichste Schichten in vielfältiger Reihenfolge auf das Substrat aufgetragen, wobei diese zumindest eine metallische Schicht umfassen. Wesentliche Anforderungen an mit einer metallischen Schicht beschichtete Substrate sind eine ausgezeichnete Korrosionsbeständigkeit sowie eine ansprechende Optik, die die beschichteten Substrate beispielsweise als vollmetallische oder verchromte Substrate erscheinen läßt. Von besonderer Bedeutung sind beschichtete Substrate in der Automobilindustrie, beispielsweise bei der Herstellung von Rädern bzw. Felgen, insbesondere Leichtmetallrädem bzw. Leichtmetallfelgen, von denen ein chromglänzendes Erscheinungsbild verlangt wird.

Aus dem Stand der Technik ist beispielsweise ein Verfahren bekannt, mit dem Leichtmetallfelgen galvanisch verchromt werden. Bei diesem Verfahren wird eine nur wenige tausendstel Millimeter dicke Chromschicht auf eine Leichtmetallfelge aufgetragen. Um nicht sämtliche Unebenheiten der Substratoberfläche wiederzugeben, müssen daher die Felgen vor der galvanischen Beschichtung geschliffen, hochglanzpoliert und gründlich vorbereitet werden. Ansonsten sind sämtliche Poren, Kratzer und Unebenheiten deutlich auf der beschichteten Felge zu erkennen. Bereits das Schleifen, Hochglanzpolieren und Vorbereiten des Substrats sind unabhängig von der Geometrie desselben sehr schwierig und arbeitsintensiv. Zudem ist der galvanische Prozeß als solcher arbeitssicherheitstechnisch aufwendig und kann bei unsachgemäßer Handhabung die Umwelt gefährden. Sobald die galvanisch aufgetragene Chromoberfläche verletzt wird, kommt es zur bekannten Kontaktkorrosion. Unter Einwirkung von z.B. Regenwasser oder Schneeschmelzwasser, das in der Regel gelöstes Streusalz enthält, entsteht eine elektrische Spannungsreihe zwischen dem edleren Teil (in diesem Falle Chrom als Deckschicht) und dem unedleren Metall des Substrats (beispielsweise einer Aluminium- bzw. Magnesiumlegierung). Dabei löst sich das unedlere Metall auf. Folglich kann z.B. eine Felge im ungünstigsten Fall bei interkristalliner Korrosion erheblich geschädigt werden, was sich in der Folge kritisch sowohl auf das optische Erscheinungsbild als auch auf die Festigkeitswerte der Felge bei dynamischer Beanspruchung während des Einsatzes auswirken kann. Von Nachteil bei der galvanischen Verchromung ist ferner, daß die galvanisch aufgebrachte Chromschicht häufig einen anderen Dehnungskoeffizienten aufweist als das darunter liegende Substratmaterial. Hierdurch können Spannungen auftreten, die zu Rissen oder sogar Abplatzungen führen.

Aus dem Stand der Technik sind ebenfalls Beschichtungsverfahren bekannt, bei denen Chrom durch Kathodenzerstäubung (Sputtern) im Hochvakuum auf einer Felge abgeschieden wird. Das Verfahren wird unter hoher elektrischer Spannung betrieben. Eine derart nach dem Sputterverfahren beschichtete Leichtmetallfelge sieht allerdings zumeist optisch nicht wie galvanisch mit Chrom beschichtet aus, d.h. metallisch glänzend, sondern eher wie Schwarzchrom und ist demzufolge mit einer dunkleren Oberfläche ausgestattet, die keinesfalls gleichwertig mit einer galvanisch beschichteten Chromoberfläche ist. Sogenannte Schwarzchrom-Oberflächen sind z.B. für sämtliche glänzenden Sanitärartikel unakzeptabel. Ferner erfüllt eine Leichtmetallfelge, die durch ein Sputter-Chrombeschichtungsverfahren hergestellt worden ist, nicht die Testanforderungen, die als Mindeststandard von der Automobilindustrie vorgeschrieben werden, wie beispielsweise die Gitterschnittprüfung nach DIN EN ISO 2409, den Salzsprühtest (Kupferchlorid/Essigsäure) nach DIN 50021-CASS(240h), die Kondenswasserkonstantklimaprüfung nach DIN 50017 KK und die Chemikalienbeständigkeitsprüfung nach VDA 621-412.

Aus der DE 102 10 269 A1 ist ein Verfahren zur haftfesten Beschichtung eines Substrats, um diesem ein metallisches Aussehen zu verleihen, bekannt, wobei zunächst auf das Substrat eine Grundierungsschicht aufgebracht und getrocknet und die Grundierungsschicht dann mit einem anorganischen Haftvermittler behandelt wird. Anschließend wird eine Silberschicht aufgetragen. Schließlich werden die aufgebrachten Schichten mit einem Schutzlack überzogen. Bei nach diesem Verfahren beschichteten Substraten findet verhältnismäßig schnell eine Oxidation der Silberschicht durch den nicht vollständig abdichtenden Schutzlack hindurch statt. Dieses führt zu einer Enthaftung der Silberschicht von dem Substrat und schließlich zu einer gelblichen Verfärbung.

Zur Erzielung eines hinreichenden Korrosionsschutzes von Metallteilen werden häufig chromathaltige Beschichtungen, auch Konversionsschichten genannt, aufgebracht. Aufgrund der hellgelb irisierenden Wirkung derartiger Beschichtungen spricht man auch vom Gelbchromatieren. Anders als anodisch aufgebrachte Schutzbeschichtungen bieten Chromat-Konversionsschichten regelmäßig keinen Schutz mehr, sobald die Oberfläche verkratzt wird. Chromatierte Oberflächen können durch Tauchverfahren oder Spritz-/Sprühverfahren erhalten werden. Exemplarisch sei für die Aufbringung von Chromatschutzschichten auf die US 2,825,697 und die US 2,928,763 verwiesen. Die Applizierung einer konventionellen Konversionsschicht auf Chromatbasis ist unter anderem auch der WO 2004/014646 A1 zu entnehmen.

Eine modifizierte Chromatbeschichtung geht aus der WO 01/51681 A2 hervor, wonach eine geeignete Passivierungslösung Chrom-(III)chlorid und Natriumnitrat zu enthalten hat.

In der DE 197 02 566 C2 wird das Verfahren zur Glanzbeschichtung von Fahrzeugteilen mit Hilfe einer Chromatschicht schließlich dahingehend modifiziert, daß auf eine auf der Chromatschicht vorliegende Pulverlackschicht eine Hochglanzschicht aus einem Metall mit Hilfe eines Magnetrons im Vakuum aufgebracht wird. Hierdurch lassen sich, ohne daß es der Zugabe externer Pigmente bedarf, gezielt Farbeffekte einstellen.

Des weiteren ist aus der WO 01/51681 A2 und der DE 602 00 458 T2 bekannt, daß Metallschichten nicht nur durch Behandeln mit einer Passivierungs- bzw. Konversionslösung enthaltend Chromat korrosionsbeständig gemacht werden können, sondern daß hierfür ebenfalls schwerlösliche Metallphosphatüberzüge, beispielsweise auf Zink- oder Eisenphosphatbasis, eingesetzt werden können.

Zur chromfreien Oberflächenbehandlung kann gemäß der DE 103 32 744 A1 auch auf ein wäßriges Gemisch enthaltend ein zumindest teilweise hydrolysiertes fluorfreies Silan und ein zumindest teilweise hydrolysiertes fluorhaltiges Silan zurückgegriffen werden.

Nach der DE 602 00 458 T2 läßt sich eine hinreichende Korrosionsbeständigkeit dadurch erzielen, daß der Korrosionsschutzanstrich ein metallisches Zinkpulver und mindestens einen Metallsalzrostinhibitor enthält, wobei dieses Metallsalz auf Magnesium, Aluminium, Calcium und Barium zurückgeht und über eine durchschnittliche Durchmessergröße von nicht mehr als 1 µm verfügt. Das Metall des Metallsalzes hat basischer als Zink zu sein.

Ein guter Korrosionsschutz stellt sich nach der DE 100 49 005 A1 dann ein, wenn die Verfahrensstufe der Behandlung mit einem Passivierungsmittel mit der der Aufbringung eines Gleitmittels zusammenfällt. Vorraussetzung hierfür ist, daß das das Gleitmittel enhaltende Mittel nicht im wesentlichen aus Titan oder/und Zirkonium sowie Fluor und einem Polymer besteht. Diese Neuentwicklung macht im wesentlichen Gebrauch von langkettigen Molekülresten, die, wie von oberflächenaktiven Substanzen, z.B. Tensiden, bekannt, zur Selbstanordnung neigen. Dementsprechend ist diese Technologie auch unter SAM-Beschichtung bekannt (Self Assembling Molecules).

Eine chromfreie Oberflächenbeschichtung von Metallen, die sich mit hohen Beschichtungsgeschwindigkeiten auftragen läßt, basiert gemäß der DE 101 49 148 A1 auf einer wäßrigen Zusammensetzung, enthaltend einen organischen Filmbildner, der mindestens ein wasserlösliches oder wasserdispergiertes Polymer mit einer Säurezahl im Bereich von 5 bis 200 enthält, mindestens eine anorganische Verbindung in Partikelform mit einem mittleren Partikeldurchmesser im Bereich von 0,005 bis zu 0,3 µm und mindestens ein Gleitmittel, wobei der aufgetragene getrocknete Film eine Schichtdicke im Bereich von 0,01 bis 10 µm, eine Pendelhärte von 50 bis 180 s und eine solche Flexibilität aufweist, daß beim Biegen über einem konischen Dorn nach DIN ISO 6860 keine Risse länger als 2 mm entstehen. Als organische Filmbildner kommen Kunstharze auf der Basis von Acrylaten, Butadienen, Ethylen, Polyester, Polyurethan, Siliconpolyestern, Epoxiden, Phenol, Styrol und Harnstoff-Formaldehyd in Betracht.

Die US 6,896,920 B2 offenbart eine mehrlagige Glanzbeschichtung, bei der zunächst auf eine metallische Substratoberfläche eine Polymerschicht aufzubringen ist. Anschließend ist diese Polymerbeschichtung mit einer Metallschicht zu versehen. Auf diese Metallschicht wird sodann eine korrosionshindernde anorganische Schicht aufgetragen. Die abschließende, oberste Schicht dieses mehrlagigen Systems stellt eine transparente Schutzlackschicht dar. Obwohl als korrosionshindernd ausgewiesen, wird bei den mehrschichtigen Substraten gemäß der US 6,896,920 B2 beim CASS-Salzsprühnebeltest bereits nach 168 Stunden eine korrosionsbedingte Veränderung der Oberfläche festgestellt. Die Automobilindustrie fordert jedoch regelmäßig den Nachweis einer unveränderten Oberfläche auch noch nach 240 Stunden.

Aufgabe der vorliegenden Erfindung ist es, ein Verfahren zur Herstellung korrosionsgeschützter und insbesondere hochglänzender Substrate bereitzustellen, das bzw. die die Nachteile des Stands der Technik überwinden. Insbesondere liegt der Erfindung die Aufgabe zugrunde, ein Verfahren verfügbar zu machen, mit dem korrosionsgeschützte Substrate zugänglich werden, die selbst bei mechanischer Beanspruchung oder Beschädigung über einen langen Zeitraum extrem korrosionsbeständig sind und eine sehr ansprechende Optik zeigen bzw. behalten, wie sie herkömmlicherweise allenfalls mittels galvanischer Verchromung erhalten wird.

Diese Aufgabe wird erfindungsgemäß gelöst durch ein Verfahren zur Herstellung eines mindestens bereichsweise korrosionsgeschützten, insbesondere glänzenden, metallischen und/oder nicht-metallischen Substrats, gemäß den Merkmalen des Patentanspruchs 1.

In der metallischen Schutzschicht liegt mindestens eine der Verbindungen, Säuren und/oder Salze des zweiten Metalls, des zweiten Edelmetalls oder der zweiten Metallegierung verteilt bzw. einbettet in dem ersten Metall, dem ersten Edelmetall oder der ersten Metallegierung vor. Besonders bevorzugt liegt die Verbindung des zweiten Metalls, Edelmetalls oder der Metallegierung im wesentlichen gleichmäßig verteilt in dem ersten Metall, Edelmetall oder der Metallegierung vor. In einer weiteren Ausführungsform findet sich mindestens eine der genannten Verbindungen des zweiten Metalls, Edelmetalls oder der Metallegierung im wesentlichen, insbesondere gleichförmig, über die gesamte Dicke der Schutzschicht in dem ersten Metall, Edelmetall oder der Metallegierung verteilt. Die metallische Schutzschicht kann demgemäß auch als eine innige Vermengung bzw. als eine metallische Kompositschicht, enthaltend ein erstes Metall oder eine erste Metallegierung und darin vorliegend bzw. eingebettet mindestens ein Oxid, Doppeloxid, Oxid-Hydrat und/oder Oxyhalogenid des zweiten Metalls und/oder der zweiten Metallegierung, verstanden werden.

Mit dem erfindungsgemäßen Verfahren wird ein Substrat mit einer metallischen Schutzschicht erhalten, die als solche selber hoch korrosionsgeschützt ist und zudem durch Aufbringung auf ein Substrat auch dieses Substrat, sofern es sich um ein metallisches Substrat handelt, vor Korrosion schützt. Während bei nicht-metallischen Substraten die Eigenschaft des Korrosionsschutzes sich somit auf die metallische Schutzschicht bezieht, wird bei metallischen Substraten nicht nur eine selber korrosionsgeschützte metallische Schutzschicht erhalten, vielmehr stattet diese Schutzschicht das metallische Substrat mit einem sehr wirksamen Korrosionsschutz aus. Gleichzeitig ist diese metallische Schutzschicht in der Regel hochglänzend, so daß hochglänzende, sehr beständige Substratoberflächen zugänglich werden.

Unter den zweiten Metallen Zirkonium, Titan und Hafnium wird, besonders bevorzugt auf Zirkonium zurückgegriffen. Selbstverständlich können auch beliebige Mischungen von Verbindungen eines zweiten Metalls oder einer zweiten Metallegierung, beispielsweise ein oder mehrere Oxide, Doppeloxide, Oxid-Hydrate und/oder Oxyhalogenide, insbesondere Oxyfluoride, nebeneinander in der Metallschicht unter Ausbildung der metallischen Schutzschicht vorliegen.

Ferner können auch beliebige Mischungen von Verbindungen mehrerer zweiter Metalle oder Metallegierungen, z.B. Zirkondioxid und Titandioxid, nebeneinander in der metallischen Schutzschicht vorliegen. Ersichtlich ist das erfindungsgemäße Verfahren technisch weit von einer herkömmlichen galvanischen Verchromung entfernt, gleichwohl lassen sich hinsichtlich Glanzeffekt, Glanzbeständigkeit und Korrosionsbeständigkeit mindestens ebenbürtige Ergebnisse erzielen.

Geeignete Substrate können sowohl metallischer als auch nicht-metallischer Natur sein. Als geeignete nicht-metallische Substrate kommen z.B. solche enthaltend bzw. aus Glas, Karbonmaterialien, Keramik oder Kunststoff in Betracht. Besonders geeignete Kunststoffe stellen PVC, Polyolefine, insbesondere Polypropylen, Polyamide und Polyoxyalkylene, z.B. POM, dar. In geeigneten Substraten können neben metallischen Komponenten oder Abschnitten auch nicht-metallische Komponenten bzw. Abschnitte vorliegen.

Grundsätzlich eigenen sich als metallische Substrate Formkörper aus allen Metallen, Metallegierungen und Edelmetallen. Als geeignete Substrate seien exemplarisch solche aus Aluminium, Eisen, Stahl, Edelstahl, Kupfer, Messing, Magnesium, Iridium, Gold, Silber, Palladium, Platin, Ruthenium, Molybdän, Nickel, Bronze, Titan, Zink, Blei, Wolfram oder Mangan sowie deren Legierungen genannt. Bevorzugte Metallsubstrate bzw. Metallsubstratoberflächen umfassen bzw. insbesondere bestehen aus Aluminium oder Aluminiumlegierungen, Magnesium oder Magnesiumlegierungen oder Titan oder Titanlegierungen. Bevorzugt wird hierbei hochreines Aluminium, Magnesium oder Titan, insbesondere mit einem Aluminium-, Magnesium- bzw. Titananteil von mindestens 90 Gew.-%, insbesondere mindestens 99 Gew.-%, bezogen auf das Gesamtgewicht der metallischen Schutzschicht, eingesetzt. Besonders bevorzugt wird für die metallischen Substrate auf Aluminium und Aluminiumlegierungen zurückgegriffen.

Gemäß einer Weiterentwicklung umfaßt das erfindungsgemäße Verfahren in einer bevorzugten Ausführungsform ferner zwischen den Schritten a) und c) den Schritt:
b) Aufbringen zumindest einer ersten Grundierungsschicht auf das, insbesondere metallische oder Kunststoff-, Substrat und/oder Schleifen und/oder Polieren der, insbesondere metallischen, Substratoberfläche.

Als besonders geeignet hat sich für metallische Substrate ein Verfahren erwiesen, umfassend nach Schritt a) die folgenden Schritte:
b) Aufbringen zumindest einer ersten Grundierungsschicht auf das Substrat und/oder Schleifen und/oder Polieren der Substratoberfläche,
c)i) Aufbringen einer Metallschicht, umfassend mindestens ein erstes Metall oder zumindest eine erste Metallegierung, auf die erste Grundierungsschicht und/oder auf die polierte und/oder geschliffene Substratoberfläche mittels Physical Vapor Deposition (PVD)-Beschichtung, Aufdampfen mittels eines Elektronenstrahl-Verdampfers, Aufdampfen mittels eines Widerstandsverdampfers, Induktionsverdampfung, ARC-Verdampfung und/oder Kathodenzerstäubung (Sputter-Beschichtung), und
c)ii) Behandeln der Metallschicht mit einem flüssigen, insbesondere wäßrigen System, enthaltend mindestens ein Oxid, Doppeloxid, Oxid-Hydrat, Oxyhalogenid eine Säure und/oder ein Salz des zweiten Metalls unter Ausbildung einer metallischen Schutz- bzw. Kompositschicht.

Dabei kann vorgesehen sein, daß mindestens eine zweite Grundierungsschicht auf die erste Grundierungsschicht aufgebracht wird.

Hierbei ist es häufig von Vorteil, daß die erste und/oder zweite Grundierungsschicht nach dem Aufbringen in zumindest einem anschließenden Wärmebehandlungsschritt ausgehärtet und/oder eingebrannt werden.

Alternativ zur Aufbringung einer ersten und gegebenenfalls zweiten Grundierungsschicht oder zusätzlich zu der Aufbringung einer Grundierungsschicht kann eine vorgeschaltete mechanische Glättung der Metallsubstratoberfläche, beispielsweise mittels Schleifens und/oder Polierens bzw. Gleitschleifens, vorgesehen sein. Geschliffene bzw. polierte Metalloberfläche verfügen häufig bereits über eine solche Oberflächengüte, daß durch Aufbringung einer metallischen Schutz- bzw. Kompositschicht gemäß Schritt c) des erfindungsgemäßen Verfahrens ein sehr korrosionsgeschütztes Substrat erhalten wird.

Die erste und/oder die zweite Grundierungsschicht kann bzw. können beispielsweise über ein Naßlackverfahren und/oder ein Pulverbeschichtungsverfahren aufgetragen werden. Geeignet sind zum Beispiel pulverförmige Polyesterharzverbindungen sowie Epoxid/Polyester-Pulver. Geeignete Epoxidharze als Grundierungsschichtmaterialien sind im Handel z.B. unter dem Markennamen "Valophene" bekannt. Als erste und zweite Grundierungsschichten kommen auch solche basierend auf einem Urethanharz, wie in der US 4,431,711 beschrieben, in Betracht. Alternativ kann ebenfalls auf Polyester- oder Polyacrylatmaterialien, wie in der WO 2004/014646 A1 hervorgehoben, zurückgegriffen werden. Ganz besonders bevorzugt wird zum Zweck der Grundierung auf Naßlackverfahren zurückgegriffen. Besonders bevorzugt sind solche Grundierungsverfahren, bei denen die Härtung der Grundierungsschicht nicht thermisch, sondern mittels UV-Bestrahlung erfolgt. Bei der Härtung mittels UV-Strahlung ist regelmäßig keine zusätzliche Erwärmung erforderlich, auch wird im allgemeinen hierbei keine Wärme generiert. Geeignete Pulverlack-, Naßlack- und UV-härtende Beschichtungssysteme sowie deren Aufbringung sind dem Fachmann hinlänglich bekannt. Je nach Oberflächenbeschaffenheit (z.B. porös oder rauh) können eine oder mehrere Grundierungsschichten aufgetragen werden, um die Oberfläche zu glätten. Insbesondere mit der ersten Grundierungsschicht, wie sie vorliegend insbesondere auf Metallsubstratoberflächen zum Einsatz kommen kann, wird im allgemeinen eine vorteilhafte Einglättung der Oberfläche erzielt. Die Grundierungsschicht stellt somit regelmäßig eine sogenannte Glättungsschicht dar. Mit einer Grundierungsschicht werden im allgemeinen sämtliche Winkelbereiche erreicht, so daß auch in diesen Bereichen Oberflächenrauhigkeiten ausgeglichen werden können.

Erfindungsgemäß kann ferner vorgesehen sein, eine herkömmliche Konversionsschicht, z.B. wie in der US 2,825,697 oder der US 2,928,763 beschrieben, auf das Substrat aufzutragen. Alternativ oder zusätzlich kann gemäß einer weiteren Ausführungsform die beschichtbare Oberfläche des Substrats mit einem wäßrigen System, enthaltend mindestens eine Säure, ein Oxid, ein Doppeloxid, ein Oxid-Hydrat, ein Sulfit, ein Halogenid, Nitrid, Carbid, Carbonitrid, Borid, Silicid, ein Oxihalogenid und/oder ein Salz eines zweiten Edelmetalls und/oder einer zweiten Metallegierung, wie vorangehend beschrieben, behandelt werden (Schritt a').

Stellt das Substrat ein Metallsubstrat dar, hat es sich regelmäßig als vorteilhaft erwiesen, insbesondere wenn dieses Metallsubstrat unmittelbar dem jeweiligen Fertigungsprozeß entnommen ist, die Oberfläche des Substrats in geeigneter Weise zu reinigen. Beispielsweise kann in einem ersten vorbereitenden Schritt die Metallsubstratoberfläche mit alkalischen oder sauren Reagenzien entfettet werden. Solche Entfettungsmittel werden unter anderem von der Firma Henkel KGaA unter der Markenbezeichnung Riduline^{®} angeboten. Damit keine Entfettungsreagenzien auf der Oberfläche verbleiben, die die nachfolgenden Bearbeitungsschritte gegebenenfalls beeinträchtigen könnten, schließt sich regelmäßig ein Spülschritt mit Wasser an. Kommerzielle Entfettungsschritte sind auch unter den Begriffen Abkoch- bzw. Beizentfetten bekannt. Alternativ kann eine Metalloberfläche in einem elektrolytischen Entfettungsbad anodisch entfettet werden.

Überdies hat es sich in manchen Fällen als zweckmäßig erwiesen, die Oberfläche des Metallsubstrats, insbesondere die entfettete Metallsubstratoberfläche, mindestens einem Dekapierschritt zu unterziehen. Für die Dekapierung der Metallsubstratoberfläche setzt man z.B. ein saures Spülbad ein. Eine geeignete Dekapierlösung stellt demgemäß z.B. verdünnte Salzsäure (1:10 vol/vol) dar. Im Ergebnis erhält man in der Regel eine im wesentlichen oxidfreie Metalloberfläche.

Ebenso wie der Entfettungsschritt wird auch der Dekapierschritt im allgemeinen durch einen Spülschritt abgeschlossen. Hierbei hat es sich als sehr wirksam erwiesen, zumindest gegen Ende des Spülgangs, vorzugsweise während des gesamten Spülgangs, VE-Wasser zu verwenden.

In einer bevorzugten Ausführungsform wird die metallische Schutz- bzw. Kompositschicht gemäß Schritt c) oder die Metallschicht gemäß Schritt c) i) des erfindungsgemäßen Verfahrens auf einer entfettenden und/oder dekapierten Metallsubstratoberfläche aufgetragen. Gemäß einer weiteren Ausführungsform kann auch die erste und gegebenenfalls die zweite Grundierungsschicht auf einer entfettenden und/oder dekapierten Metallsubstratoberfläche aufgetragen werden.

Wird die Metallsubstratoberfläche poliert und/oder geschliffen bzw. gleitgeschliffen, kann häufig der Entfettungs- und/oder Dekapierschritt entfallen. Üblicherweise wird bei dieser Art der Oberflächenbearbeitung hinreichend Material von dieser Oberfläche abgetragen, womit dann auch auf der Oberfläche aufliegende bzw. anhaftende Verunreinigungen oder anderweitige Bestandteile mit entfernt werden. Wird die Oberfläche poliert bzw. geschliffen, kann überdies häufig auch auf die Auftragung einer ersten und gegebenenfalls zweiten Grundierschicht verzichtet werden. Mit dem Polieren bzw. Schleifen wird zumeist bereits eine derart ebene bzw. glatte Oberfläche erhalten, daß eine Einglättung durch Aufbringen einer Grundierschicht nicht mehr erforderlich ist. Allenfalls wenn das Metallsubstrat zahlreiche Winkel und Ecken aufweist, die sich nicht ohne weiteres hinreichend polieren bzw. schleifen lassen, kann es empfehlenswert sein, einen ersten und möglicherweise auch einen zweiten Grundierschritt nachzuschalten.

Glas- und Keramiksubstrate sind in der Regel bereits per se so glatt, daß es eines Polierschritts oder der Aufbringung zusätzlicher Grundierschichten nicht bedarf. Dieses trifft im allgemeinen auch auf Kunststoffsubstrate zu. Sollen Kunststoffsubstrate mit einer besonders glatten Oberfläche, insbesondere mit hoher Zuverlässigkeit, erhalten werden, trägt man zumeist mindestens eine Grundierungsschicht auf. Geeignete Grundierungsschichten für Kunststoffsubstrate stellen z.B. Klarlacke oder UV-Lacke dar. Holzsubstrate, zum Teil auch geschliffene und/oder polierte Holzsubstrate, bedürfen hingegen mindestens einer Grundierschicht, bevor die metallische Schutzschicht bzw. die Metallschicht aufgetragen werden kann.

Gemäß einer weiteren optionalen Ausgestaltung der Erfindung ist vorgesehen, daß vor dem Schritt c) zumindest ein Haftvermittler für die metallische Schutzschicht bzw. die Metallschicht auf die Oberfläche des Substrats, der ersten Grundierungsschicht und/oder der zweiten Grundierungsschicht aufgebracht bzw. auf dieser Oberfläche erzeugt wird. Ein geeigneter Haftvermittler kann z.B. durch mindestens eine Plasmavorbehandlung, vorzugsweise mittels zumindest eines Sauerstoffplasmas und/oder zumindest eines Polymerplasmas, insbesondere umfassend Hexamethyldisiloxan, erzeugt bzw. aufgetragen werden. Auch kann vorgesehen sein, daß als Haftvermittler zumindest ein anorganischer oder metallorganischer Haftvermittler aufgebracht wird. Dabei wird bevorzugt auf ein Zinn(II)-Salz in saurer Lösung oder zumindest ein aminhaltiges Silan in alkalischer Lösung zurückgegriffen.

Kunststofformkörper, die mit dem erfindungsgemäßen Verfahren behandelt werden können, können z.B. gefertigt sein aus ABS, SAN, ASA, PPE, ABS/PPE, ASA/PPE, SAN/PPE, PS, PVC, PC, ABS/PC, PP, PE, EPDM, Polyacrylaten, Polyamiden, POM oder Teflon. Sollte die Aufbringung einer Grundierungsschicht erforderlich sein, werden diese Grundierungsmaterialien bevorzugt im Naßlackverfahren aufgetragen. Bei hoch hitzebeständigen Kunststoffen kommt ebenfalls das Pulverlackverfahren in Kraft.

Vor dem Auftragen der metallischen Schutz- bzw. Kompositschicht gemäß Schritt c) oder der Metallschicht gemäß Schritt c) i) wird die Substratoberfläche vorzugsweise getrocknet, um frei von Wasserresten zu sein.

Vorteilhafterweise werden nach dem Verfahrensschritt c) die erhaltenen Oberflächen mit Wasser gespült. Bevorzugt wird zumindest gegen Ende dieses Spülschritts, vorzugsweise während des gesamten Spülschritts, vollentsalztes Wasser (auch als VE-Wasser bekannt) verwendet.

Die Dicke der gemäß Verfahrensschritt c) des erfindungsgemäßen Verfahrens auf das Substrat aufzubringenden metallischen Schutz- bzw. Kompositschicht oder der Metallschicht gemäß Schritt c)i) liegt im Bereich von 20 nm bis 120 nm. Sehr zufriedenstellende Resultate werden beispielsweise mit Schichtdicken im Bereich von 50 nm bis 120 nm erzielt. Die erfindungsgemäßen Resultate stellen sich regelmäßig bereits mit durchschnittlichen Schichtdicken kleiner 100 nm ein.

Erfindungsgemäß umfassen das erste Metall und die erste Mettalegierung für die metallische Schutz- bzw. Kompositschicht gemäß Schritt c) bzw. die Metallschicht gemäß Schritt c)i) insbesondere Aluminium, Messing, Bronze, Magnesium, Titan, Zink oder Edelstahl. Eine besonders geeignete Schutz-/Komposit- bzw. Metallschicht umfaßt Aluminium oder eine Aluminiumlegierung.

Insbesondere bevorzugt ist, daß die Reinheit des ersten Metalls, vorzugsweise des Aluminiums, mindestens 80 Gew.-%, vorzugsweise mehr als 90 Gew.-%, am besten mindestens 99 Gew.-%, beträgt.

Für die Aufbringung der metallischen Schutzschicht gemäß Schritt c) bzw. der Metallschicht gemäß Schritt c)i) wird auf das Verfahren der Physical Vapor Deposition (PVD)-Beschichtung, das Aufdampfen mittels eines Elektronenstrahl-Verdampfers, das Aufdampfen mittels eines Widerstandsverdampfers, die Induktionsverdampfung, die ARC-Verdampfung und die Kathodenzerstäubung (Sputter-Beschichtung), jeweils in einem Hochvakuum, zurückgegriffen. Diese Verfahren sind dem Fachmann bekannt. Die metallische Schutz- bzw. Kompsitschicht oder die Metallschicht können beispielsweise auf dem Substrat bzw. auf dessen beschichtbarer Oberfläche, der ersten Grundierungsschicht, der zweiten Grundierungsschicht und/oder dem Haftvermittler aufgebracht werden. Bevorzugt wird ein Physical Vapor Deposition-Beschichtungsverfahren (PVD) eingesetzt. Dabei kommen widerstandsbeheizte Metallwendel- oder Metallschiffchenverdampfer zum Einsatz, wobei Wolframwendeln der verschiedensten Form bevorzugt sind. Beim PVD-Verfahren wird im allgemeinen ein Verdampfer mit Wendeln bestückt, die auf voneinander isolierten Verdampferschienen geklemmt werden können. In jede Wendel wird vorzugsweise eine genau bestimmte Menge an ersten Metall, Edelmetall oder erster Metallegierung gegeben. Nach dem Schließen und Evakuieren der PVD-Anlage kann die Verdampfung durch Einschalten der Stromversorgung, wodurch man die Verdampferschienen die Wendel zum Glühen gebracht, gestartet werden Das feste Metall beginnt zu schmelzen und benetzt die meist verdrillten Wendeln vollständig. Durch weitere Energiezufuhr wird das flüssige Metall in die Gasphase überführt, so daß es sich auf dem zu beschichtenden Substrat abscheiden kann.

Die Verdampfung aus Metallschiffchen läuft in ähnlicher Weise ab. Die Verdampferausrüstung ist dabei prinzipiell identisch, jedoch werden Schiffchen meist aus hochschmelzenden Metallblechen eingesetzt, wie Wolfram-, Tantal- oder Molybdän-Schiffchen.

Ein weiteres bevorzugtes Verfahren zur Abscheidung der Metallschicht auf dem Substrat ist die Kathodenzerstäubung (Sputter-Verfahren). Dabei wird in einem evakuierten Behälter eine Kathode angeordnet, die mit dem negativen Pol einer Stromversorgung verbunden ist. Das Beschichtungsmaterial, das zerstäubt wird, wird unmittelbar vor der Kathode montiert und die zu beschichtenden Substrate werden gegenüber dem zu zerstäubenden Beschichtungsmaterial angeordnet. Ferner kann Argon als Prozeßgas durch den Behälter geleitet werden, der schließlich noch eine Anode aufweist, die mit dem positiven Pol einer Stromversorgung verbunden ist. Nachdem der Behälter vorevakuiert worden ist, werden Kathode und Anode mit der Stromversorgung verbunden. Durch den gezielten und gesteuerten Einlaß von Argon wird die mittlere freie Weglänge der Ladungsträger deutlich gesenkt. Im elektrischen Feld zwischen Kathode und Anode werden Argonatome ionisiert. Die positiv geladenen Teilchen werden mit hoher Energie zur negativ geladenen Kathode beschleunigt. Beim Auftreffen und durch Teilchenstöße im Beschichtungsmaterial wird dieses in die Dampfphase überführt, mit hoher Energie in den freien Raum beschleunigt und kondensiert dann auf den zu beschichtenden Substraten.

Weitere in dem erfindungsgemäßen Verfahren einsetzbare Aufdampfverfahren erfolgen unter Einsatz einer Elektrodenstrahl-Verdampfung, Widerstandsverdampfung, Induktionsverdampfung und/oder einer Verdampfung mit Hilfe eines thermischen, nichtstationären Bogens (ARC-Verdampfung).

Im übrigen sind Verfahren zur Aufbringung einer Metallschicht auf ein metallisches oder nicht-metallisches Substrat dem Fachmann bekannt.

Auch kann bei dem erfindungsgemäßen Verfahren vorgesehen sein, daß nach dem Schritt c) bzw. c)ii) zunächst zumindest ein Wärmebehandlungsschritt durchgeführt wird.

Vor dem Behandeln der Metallschicht gemäß Schritt c)i) mit einem wäßrigen System, enthaltend mindestens eine Säure, ein Oxid, Doppeloxid, Oxid-Hydrat, Oxyhalgonid und/oder Salz des zweiten Metalls wird die Metallschicht mit VE-Wasser benetzt oder gespült. Vorzugsweise verfügt das hierfür eingesetzte Wasser über einen Leitwert kleiner 100 mS/cm, vorzugsweise kleiner 50 mS/cm und besonders bevorzugt kleiner 35 mS/cm.

Das wäßrige System kann z.B. in Form einer Lösung, einer Suspension oder einer Emulsion vorliegen. Bevorzugt wird das wäßrige System als Lösung eingesetzt, d.h. die vorangehend genannten Verbindungen, Salze und/oder Säuren liegen darin zumindest vor der Applikation im wesentlichen gelöst vor.

In den Substraten liegen das Oxid, Doppeloxid, Oxid-Hydrat und/oder Oxihalogenid des zweiten Metalls vorzugsweise basierend Zirkonium, in Mengen von 0,2 bis 10 Gew.-%, vorzugsweise im Bereich von 1 bis 7 Gew.-% und besonders bevorzugt im Bereich von 1,5 bis 5 Gew.-%, bezogen auf das Gesamtgewicht der metallischen Schutz- bzw. Kompositschicht, in dieser Schutz- bzw. Kompositschicht vor.

In der metallischen Schutz- bzw. Kompositschicht liegt mindestens ein Oxid, Doppeloxid, Oxid-Hydrat und/oder Oxyhalogenid des zweiten Metalls vor, insbesondere Zirkoniumfluorid, Zirkoniumoxyfluorid und/oder Zirkoniumdioxid. Zirkoniumdioxid ist besonders bevorzugt. Als Doppeloxide kommen z.B. Aluminium/Zirkoniumoxide in Betracht. Ferner ist gemäß einer weiteren Ausführungsform bevorzugt, daß in der Kompositschicht das zweite Metall auf der Basis des Zirkoniums, Titans und/oder Hafniums oxidisch gebunden vorliegt.

Ohne an irgendeine Theorie gebunden zu sein, wird gegenwärtig angenommen, daß die Verbindungen des zweiten Metalls, die in dem wäßrigen System z.B. als Säure oder Salz vorliegen, in der metallischen Schutzschicht in ein Oxid, Doppeloxid, Oxid-Hydrat oder Oxyhalogenid überführt vorliegen.

Geeignete Säuren, die auf ein Element der 4. Gruppe zurückgehen, umfassen z.B. Hydrofluorzirkonsäure (H₂ZrF₆), Fluortitansäure (H₂TiF₆) und Fluorhafniumsäure (H₂HfF₆). Selbstverständlich können auch Mischungen unterschiedlicher Säuren eingesetzt werden. Diese Fluorsäuren können sowohl im Reinzustand als auch enthaltend Verunreinigungen, beispielsweise Fluorsäure, eingesetzt werden. In den wäßrigen Systemen können die Säuren z.B. in Mengen von bis zu 5 Gew.-%, insbesondere von bis zu 3,5 Gew.-%, bezogen auf das Gesamtgewicht des wäßrigen Systems, vorliegen.

Fluorsäure kann in den wäßrigen Systemen, z.B. in Mengen im Bereich von 0,1 bis 3 Gew.-%, ebenfalls zugegen sein.

Unter den geeigneten Salzen wird bevorzugt auf Ammoniumzirkoniumcarbonat, das beispielsweise von der Firma Magnesium Electron Inc. unter der Markenbezeichnung Bacote 20 erhältlich ist, eingesetzt ((NH₄)₂[Zr(OH)₂(CO₃)₂]·n H₂O). Ferner können auch Alkalimetall- und Ammoniumfluorzirkonate, beispielsweise Na₂ZrF₆, KZrF₆, (NH₄)ZrF₆, ebenso wie Zirkoniumnitrate, Zirkoniumoxynitrate, Zirkoniumcarbonate, Zirkoniumfluoride oder Zirkoniumsulfat eingesetzt werden. Die Verbindungen basierend auf der 4. Gruppe können als solche oder in beliebiger Mischung miteinander eingesetzt werden.

Selbstverständlich ist es ebenfalls möglich, den wäßrigen Systemen neben den genannten Verbindungen oder deren Mischungen weitere Bestandteile zuzumischen. Hierfür kommen u.a. Salpetersäure, Fluorsäure, Phosphorsäure, Salze der genannten Säuren, Ammoniumbifluorid und Ammoniumsulfat in Betracht. Ein geeignetes Titansalz stellt z.B. Ammoniumtitanfluorid dar.

Bevorzugt enthält das wäßrige System Fluoridionen in freier und/oder komplexierter Form. Als geeignete komplexierte Fluoridionen seien Fluoroboratsalze und -säuren sowie Alkalimetall- und Ammoniumbifluoride genannt. Ganz allgemein sind komplexe Fluoride des Titans, Zirkoniums, Hafniums, Siliziums und/oder Bors besonders geeignet. Bevorzugt wird auf Komplexe Fluoride als Zirkoniums zurückgegriffen.

Geeignete wäßrige Systeme können vorzugsweise neben der Säure, einem Oxid, Doppeloxid, Oxid-Hydrat, Oxyhalogenid

und/oder Salz des zweiten Metalls basierend auf Zirkonium, Titan und/oder Hafnium mindestens eine polymere Verbindung enthalten, die in der wäßrigen Zusammensetzung gelöst, in Emulsionsform oder in Form ungelöster dispergierter Partikel vorliegen kann.

Unter den polymeren Verbindungen seien insbesondere die Polyacrylsäure sowie deren Salze und Ester genannt. Diese Säuren, Ester und Salze können in der wässrigen Lösung in gelöster oder in dispergierter Form vorliegen. Die Menge an Polymerkomponente kann in weiten Bereichen variiert werden und liegt vorzugsweise im Bereich von 0,1 bis 0,5 g pro Liter.

Als polymere Materialien kommen des weiteren Polymethylvinylmaleinsäure und Polymethylvinylmaleinsäureanhydrid in Frage. Geeignete Polyacrylsäuren verfügen idealerweise über ein Molekulargewicht von bis zu 500.000. Bevorzugt wird auch häufig auf Mischungen in Frage kommender Polymerverbindungen zurückgegriffen. Beispielsweise seien Mischungen enthaltend Polyacrylsäure, deren Salze oder Ester mit Polyvinylalkohol genannt. Geeignete Polymere umfassen ferner Hydroxyethylether der Cellulose, Ethylenmaleinsäureanhydrid, Polyvinylpyrolidin und Polyvinylmethylether.

Besonders bevorzugte polymere Komponenten im Sinne der vorliegenden Erfindung umfassen einen quervernetzten Polyester, enthaltend eine Vielzahl an Carbonsäurefunktionalitäten und eine Vielzahl an Hydroxylgruppen, die teilweise oder vollständig miteinander reagiert haben können. Bei diesem quervernetzten Polyesterpolymer kann es sich z.B. um das Reaktionsprodukt eines ersten Polymers, enthaltend Carbonsäurefunktionalitäten, mit einem zweiten Polymer, enthaltend Hydroxylgruppen, handeln. Beispielsweise kommen Polyacrylsäure und Polymethylvinylmaleinsäureanhydrid als solche ersten Polymere in Betracht, während Polyvinylalkohol ein geeignetes zweites Polymer darstellt. Interessanterweise eignet sich sowohl das Reaktionsprodukt der vorangehend genannten ersten und zweiten Polymere als auch deren Mischung als Bestandteil des wäßrigen Systems zur Behandlung nach dem erfindungsgemäßen Verfahren. Überdies kann eine solche wäßrige Lösung zusätzlich vorzugsweise Fluorsäure enthalten. Als geeignete Salze der genannten Polyacrylsäure kommen z.B. Ammoniumsalze in Frage.

Außerdem kommt als geeignetes Polymer 3-(N-C₁₋₄-Alkyl-N-2-hydroxethylarninomethyl)-4-hydroxystyrol in Betracht, insbesondere wenn als Verbindung der 4. Gruppe Hexafluorzirkonsäure eingesetzt wird. Zusätzlich kann gegebenenfalls auch das Homopolymer des 4-Hydroxystyrols zugegen sein, mit einem mittleren Molekargewicht im Bereich von 3000 bis 6000. Diesbezügliche Details können der US 5,089,064 entnommen werden.

Die wäßrigen Systeme können des weiteren Fettsäuren, Fettalkohole und/oder insbesondere Fettamine oder deren beliebige Mischungen enthalten. Die Fettamine können auch in Form ihrer Ammoniumsalze vorliegen. Fettamine im Sinne der vorliegenden Erfindung umfassen somit auch die korrespondierenden Ammoniumsalze. Hierbei wird bevorzugt auf Verbindungen mit gesättigten Fettalkylketten zurückgegriffen. Die Länge der linearen Fettalkylketten liegt bevorzugt im Bereich von C₈ bis C₂₄. Bevorzugte Fettamine bzw. die entsprechende Ammoniumverbindungen basieren auf einem C₁₂-, C₁₄- , C₁₆- oder C₁₈-Alkylrest. Geeignete Fettsäuren umfassen z.B. Caprinsäure.

Darüber hinaus können geeignete wäßrige Systeme mit Polyoxyalkylenglycolether, insbesondere Polyoxyethylenglycolethern, Polypropylenglycolethern und deren Mischungen, versetzt sein. Hierbei kann auf alle gängigen kommerziell erhältlichen Glycolether zurückgegriffen werden.

Geeignete pH-Werte für die wäßrigen Systeme liegen bzw. werden vorzugsweise im Bereich von 1,5 bis 6,5, bevorzugt im Bereich von 1,5 bis 5,0, und insbesondere von 2,0 bis 4,5 gehalten. Soll der pH-Wert der wäßrigen Systeme angehoben werden, eignen sich hierfür vor allem Gaben an Ammoniak oder Ammoniumhydroxid, z.B. in Form einer 3%-igen Ammoniaklösung. Daneben kann auf konventionelle, dem Fachmann bekannte Basen zurückgegriffen werden.

Der Leitwert des eingesetzten wäßrigen Systems liegt vorzugsweise im Bereich von 100 bis 2000, besonders bevorzugt im Bereich von 150 bis 1500 und insbesondere im Bereich von 200 bis 1000 µS/cm.

Die vorangehend beschriebenen optionalen Komponenten des wäßrigen Systems liegen in einer bevorzugten Ausführungsform, einzeln oder in beliebiger Kombination, ebenfalls in der Metallschicht vor und sind dann ebenfalls Bestandteil der metallischen Schutz- bzw. Kompositschicht.

Gemäß der vorliegenden Erfindung ist vorgesehen, daß nach dem Aufbringen der Metallschicht gemäß Schritt c) i) und vor dem Behandlungsschritt c)ii) und vorzugsweise auch nach Schritt c), jeweils insbesondere unmittelbar, das so beschichtete Substrat einem Spülschritt mit vollentsalztem Wasser unterzogen wird. Hieran schließt sich vorzugsweise jeweils mindestens ein Trocknungsschritt zum Trocknen der Oberfläche an. Der Trocknungsschritt kann z.B. bei Temperaturen im Bereich von 120 bis 180°C, beispielsweise bei etwa 140°C, durchgeführt werden. Das zum Spülen eingesetzte Wasser verfügt vorzugsweise über einen Leitwert kleiner 60 mS/cm, vorzugsweise kleiner 50 mS/cm und insbesondere kleiner 35 mS/cm. Insbesondere der jeweils letzte Spülgang vor dem nachfolgenden Verfahrensschritt oder vor einem Trocknungsvorgang verfügt über die voranstehend genannten Leitwerte.

Der pH-Wert und/oder der Leitwert des wäßrigen Systems werden für die Dauer der Behandlung der Metallschicht vorzugsweise im wesentlichen konstant gehalten, insbesondere innerhalb der vorangehend genannten Bereiche.

Bevorzugt wird die Metallschicht unter erhöhtem Druck mit diesem wäßrigen System beaufschlagt, beispielsweise in Form von Hochdruckwasserstrahlen. Hierbei hat es sich als zweckmäßig erwiesen, eine Vielzahl an feinen Einzelwasserstrahlen auf das Substrat zu richten. Geeignete Drücke für die Beaufschlagung mit dem wäßrigen System liegen z.B. oberhalb von 0,2 bar, vorzugsweise im Bereich von 0,5 bis 50 bar und besonders bevorzugt im Bereich von 0,2 bis 15, insbesondere von 0,9 bis 1,5 bar. Diese Drücke werden auf der Oberfläche der Metallschicht gemessen. Mit der vorangehend beschriebenen Variante wird mindestens ein Oxid, Doppeloxid, Oxid-Hydrat, und/oder Oxyhalogenid des zweiten Metalls in die Metallschicht eingetragen.

Geeigneterweise liegt die Temperatur des wäßrigen Systems beim Behandlungsvorgang des Substrats im Bereich von 15 bis 50°C, bevorzugt im Bereich von 20 bis 40°C. In der Regel reicht bereits eine Behandlungsdauer von 20 bis 120 Sekunden aus, um das Substrat zu erhalten.

Bevorzugt wird das mit einer Metallschicht, insbesondere mit einer Aluminiumschicht, gemäß Schritt c)i) versehene Substrat unmittelbar nach deren Aufbringung auf die Substratoberfläche mit dem beschriebenen wäßrigen System, wie vorangehend geschildert, behandelt. Diese Vorgehensweise gelingt beispielsweise in einer Fertigungsstraße, in der das Substrat sukzessive sämtliche Fertigungsstufen durchläuft.

In einer bevorzugten Ausführungsform liegt der Anteil an Eisenionen in dem wäßrigen System nicht oberhalb 10 ppm.

Mit der Erfindung wird auch vorgeschlagen, daß nach dem Schritt c) bzw. c)ii) zumindest eine Schutzlackschicht oder Lasur aufgebracht werden kann. Der Schutzlack kann z.B. ein Klarlack oder ein transparentes Pulver sein und wird vorzugsweise über ein Naßlackverfahren bzw. ein Pulverbeschichtungsverfahren aufgetragen. Ferner sieht die Erfindung vor, daß der Schutzlack mindestens einen Farbstoff oder ein Pigment enthalten kann.

Zur Einfärbung des Substrats kann ferner insbesondere auch auf geeignete, dem Fachmann bekannte Lasuren zurückgegriffen werden. Hiermit lassen sich z.B. Messing-, Titan- und Goldtöne sowie individuelle Farbtöne wie rot, blau, gelb, grün, etc. und sämtliche Eloxalfarben ohne weiteres einstellen.

Die nach dem erfindungsgemäßen Verfahren erhältlichen Substrate können beispielsweise als Spiegel, verspiegeltes Material oder als Zubehörteil für den Automobilbaubereich verwendet werden. Bevorzugt ist die Verwendung als Leichtmetallfelge bzw. Leichtmetallrad für den Automobilbaubereich. Selbstverständlich können auch Karosseriebauteile, seien sie aus Kunststoff oder Metall, mit dem erfindungsgemäßen Verfahren mit einer metallischen Schutz- bzw. Kompositschicht versehen werden. Die nach dem erfindungsgemäßen Verfahren erhältlichen Substrate sind natürlich nicht auf die genannten Verwendungen beschränkt.

Beschichtete metallische und nicht-metallische Substrate umfassen, in dieser Reihenfolge, ein Substrat, beispielsweise aus Kunststoff, Aluminium oder einer Aluminiumlegierung, und eine metallische Schutz- bzw. Kompositschicht, wie vorangehend beschrieben, insbesondere auf der Basis von Aluminium. Gegebenenfalls liegt in dieser Ausführungsform die mit der metallischen Schutz- bzw. Kompositschicht zu versehene Substratoberfläche in geschliffener und/oder polierter Form vor. In einer weiteren, bevorzugten Ausführungsform umfaßt die beschichtete Struktur, in dieser Reihenfolge, ein Substrat, vorzugsweise mit einer geschliffenen und/oder polierten Substratoberfläche, eine, gegebenenfalls chromfreie, Konversionsschicht und eine metallische Schutz- bzw. Kompositschicht, wie vorangehend beschrieben. Gemäß einer weiteren vorteilhaften Ausgestaltung verfügt ein beschichtetes Substrat, in dieser Reihenfolge, über ein Substrat, gegebenenfalls mit polierter und/oder geschliffener Oberfläche, eine erste und gegebenenfalls eine zweite Grundierungsschicht und eine metallische Schutz- bzw. Kompositschicht, wie vorangehend beschrieben. Des weiteren umfaßt ein alternatives erfindungsgemäß beschichtetes Substrat, in dieser Reihenfolge, ein Substrat, gegebenenfalls mit polierter und/oder geschliffener Substratoberfläche, eine, vorzugsweise chromfreie, Konversionsschicht, eine erste Grundierungsschicht sowie gegebenenfalls eine zweite Grundierungsschicht, und eine metallische Schutz- bzw. Kompositschicht, wie vorangehend beschrieben. Sämtliche der vorangehend genannten Ausführungsformen können zusätzlich mit einer vorzugsweise transparenten Decklackschicht und/oder Lasurschicht bedeckt sein.

Der Erfindung liegt die überraschende Erkenntnis zugrunde, daß durch das erfindungsgemäße Verfahren ein Substrat mit einer metallischen Schutzbeschichtung bereitgestellt wird, das eine ausgezeichnete Korrosionsbeständigkeit sowie eine sehr ansprechende Chrom-Optik aufweist. Unter einer Chrom-Optik soll vorliegend eine solche verstanden werden, die sich üblicherweise nur bei der galvanischen Verchromung von Substraten einstellt. Eine derartige Optik ist mit den aus dem Stand der Technik bekannten Verfahren nicht erreichbar. Mit dem Verfahren der vorliegenden Erfindung kann ein haftfest beschichtetes, korrosionsgeschütztes, hochglänzendes Substrat auch mit komplexer Geometrie, beispielsweise eine Leichtmetallfelge oder ein Farbzeugemblem aus Kunststoff wie der Mercedes-Stern, erhalten werden, das optisch mit galvanisch verchromten Substraten identisch ist und darüber hinaus gleichzeitig alle Testanforderungen der Automobilindustrie erfüllt.

Die Substrate zeigen Korrosionsbeständigkeiten, und zwar selbst dann, wenn die Oberflächen mechanische Beschädigungen erfahren haben, beispielsweise mittels Steinschlag oder durch Anritzen. Insbesondere war auch nicht zu erwarten, daß sich Metallsubstrate, insbesondere Aluminiumsubstrate erhalten lassen, die Glanzteile darstellen, wie sie üblicherweise nur bei besonders hochwertigen Chrombauteilen anzutreffen sind. Die vorteilhaften Effekte hinsichtlich Korrosionsbeständigkeit und Glanz stellen sich natürlich auch dann ein, wenn auf die Anbringung einer Grundierungsschicht auf dem Substrat oder die Auftragung einer abschließenden Decklackschicht verzichtet wird.

Gegenüber herkömmlichen Verfahren zeichnet sich das erfindungsgemäße Verfahren durch die Verwendung ökologisch unbedenklicher Bestandteile aus und kann für die Herstellung vielfältigster Glanzbauteile verwendet werden. Exemplarisch seien genannt Radfelgen, wie beispielsweise Automobil-, Motorrad- und Fahrradfelgen, Ziergegenstände jeglicher Art, z.B. Zierleisten, Karosserieaußen- und -innenbauteile, wie Rückspiegelabdeckungen, Frontblenden, Motorhaubenabdeckungen und Konsolen, Sanitäreinrichtungsgegenstände, wie Armaturen, und Reflektorflächen, beispielsweise bei Scheinwerfern, insbesondere Automobilscheinwerfem. Ferner können jegliche Art von Griffen, beispielsweise Türgriffe, sowie jegliche Art von Rahmen, beispielsweise Fensterrahmen, und auch Verpackungsgegenstände und Gehäuse, beispielsweise aus der Kosmetikartikelindustrie, beispielsweise Lippenstiftgehäuse, nach dem erfindungsgemäßen Verfahren gefertigt sein. Darüber hinaus können beispielsweise vielfältigste Komponenten von Motor- und Fahrrädern oder sonstigen Fortbewegungsmitteln, Bauteilkomponenten, wie sie in der Möbelindustrie Verwendung finden, Rohre, Handtuchhalter, Heizkörper, Bauteile von Aufzügen, Innen- und Außenbauteile von Flugzeugen, jedwede Reflektoren, Schmuckgegenstände, Handyschalen oder Bauteile, wie sie im Hausbau zum Einsatz kommen, nach dem erfindungsgemäßen Verfahren beschichtet sein. Besonders geeignet sind die beschichteten Substrate auch für den Einsatz im Schiffbau und können sowohl für Innen- wie auch insbesondere für Außenbauteile verwendet werden. Hierbei zeigt sich die Güte der erfindungsgemäß beschichteten Produkte daran, daß eine langanhaltende Korrosionsbeständigkeit und damit einhergehend ein hochwertiger chromähnlicher Glanz auch durch Meerwasser, beispielsweise Gischt, nicht beeinträchtigt wird.

Von besonderem Vorteil ist überdies, daß Probleme aufgrund unterschiedlicher Dehnungskoeffizienten, wie sie bei galvanisch verchromten Substraten regelmäßig beobachtet werden, nicht mehr auftreten. Die nach dem erfindungsgemäßen Verfahren beschichteten Substrate neigen nicht mehr zur Rißbildung oder zum Abplatzen. Somit sind beispielsweise hochglänzende Kunststoffsubstrate zugänglich, die für vielfältigste Anwendungen, beispielsweise im Automobilbau oder bei der weißen Ware, zum Einsatz kommen können.

Die nach dem erfindungsgemäßen Verfahren beschichteten Substrate erfüllen in allen Punkten die geforderten Sollwerte beim Chemikalienbeständigkeitstest nach VDA-Prüfblatt 621-412 (Prüfung A). Ferner zeigen diese Substrate im Salzsprühnebeltest gemäß DIN 50021-CASS (Kupferchlorid/Essigsäure) auch nach 240 Stunden keine Veränderung der Oberfläche, selbst dann nicht, wenn die Metalloberfläche zuvor eingeritzt worden ist. Demgegenüber wird mit dem Mehrschichtsystem der US 6,896,970 B2, beim eine Konversionsschicht auf einer Schichtstruktur aus Polymerschicht und Metallschicht vorliegt, bei dem CASS-Test bereits nach 168 Stunden eine Veränderung der Oberfläche festgestellt. Auch werden bei den Substraten Blasenbildung und Grundmetallkorrosion nicht beobachtet. Darüber hinaus erzielen die erfindungsgemäß beschichteten Substrate im Steinschlagtest nach PV 1213 regelmäßig Kennwerte im Bereich von 0 bis 0,5. Zudem ergibt auch die Kondenswasserkonstantklimaprüfung nach DIN 50017 nach 240 Stunden keine Veränderung der Oberfläche. Schließlich zeigen diese beschichteten Substrate auch im Freibewitterungstest (Florida-Test) über einen längeren Bewitterungszeitraum von mehreren Monaten keine Veränderung. Der Glanzerhalt gemäß DIN 67530 beträgt stets nahezu 100%. Der Gitterschnittkennwert beträgt regelmäßig Gt 0.

Das erfindungsgemäße Verfahren weist insbesondere die Vorteile auf, daß es nicht notwendig ist, die zu beschichtenden Substrate, z.B. Leichtmetallfelgen, auf Hochglanz zu polieren, was bei komplexen Geometrien nur mit sehr hohem Aufwand, wenn nicht sogar ganz unmöglich ist. Die Vorbereitung des Substrats ist somit wesentlich weniger aufwendig. Hervorzuheben ist ferner die Umweltfreundlichkeit des erfindungsgemäßen Verfahrens, da Lösemittelemissionen im wesentlichen vollständig vermieden werden. Das erfindungsgemäße Verfahren liefert ein beschichtetes Substrat mit beständigem Korrosionsschutz auch bei Verletzung oder Beschädigung des Schichtsystems bis hin zum Substrat. Dadurch wird die Lebensdauer des beschichteten Substrats deutlich erhöht. Insbesondere beim Einsatz dieser Substrate im Automobilbereich, wie als Leichtmetallfelgen oder Reflektoren für Scheinwerfer, wirkt sich diese Widerstandsfähigkeit positiv aus. Ferner ergeben solche Substrate eine hervorragende Optik und damit einen Zusatznutzen im Produktdesign beispielsweise bei Verwendung des Substrats als Rad bzw. Felge. Insgesamt wird die Gesamtoptik des Automobils und damit eine optische Abgrenzung von Standardausführungen verbessert.

Weitere Merkmale und Vorteile der Erfindung ergeben sich aus der nachfolgenden Beschreibung, in der Ausführungsbeispiele der Erfindung anhand schematischer Zeichnungen im einzelnen erläutert sind. Dabei zeigen
- Figur 1a: eine schematische Teilquerschnittsansicht eines metallischen Substrats vor der Durchführung des erfindungsgemäßen Verfahrens,
- Figur 1b: das Substrat der Figur 1a nach Aufbringen einer Grundierungsschicht;
- Figur 1c: das Substrat der Figur 1b nach Aufbringen einer Metallschicht;
- Figur 1d: das Substrat gemäß Figur 1c, enthaltend eine metallische Schutz- bzw. Kompositschicht;
- Figur 1e: das Substrat gemäß Figur 1d mit transparenter Deckschicht;
- Figur 2: eine semiquantitative Darstellung der lateralen Verteilung der Elemente Al, Zr, O in der metallische Schutzschicht durch Auswertung eines EDX-Elementmaps;
- Figur 3: eine lichtmikroskopische Aufnahme an einem Mikrotomschnitt des Substrats;
- Figur 4: normierte Intensitäten ausgewählter Elemente entlang eines Linescan, wie in Figur 3 skizziert, erhalten mittels TOF-SIMS;
- Figur 5: ein XPS-Spektrum im Bereich 175 bis 190 eV;
- Figur 6a: eine schematische Teilquerschnittsansicht eines zweiten Substrats in Form eines als Reflektors für einen Scheinwerfer dienenden Kunststoffteils;
- Figur 6b: das Substrat der Figur 6a nach Aufbringen der Metallschicht; und
- Figur 6c: das Substrat der Figur 6b nach Behandlung der Metallschicht mit dem wäßrigen System.

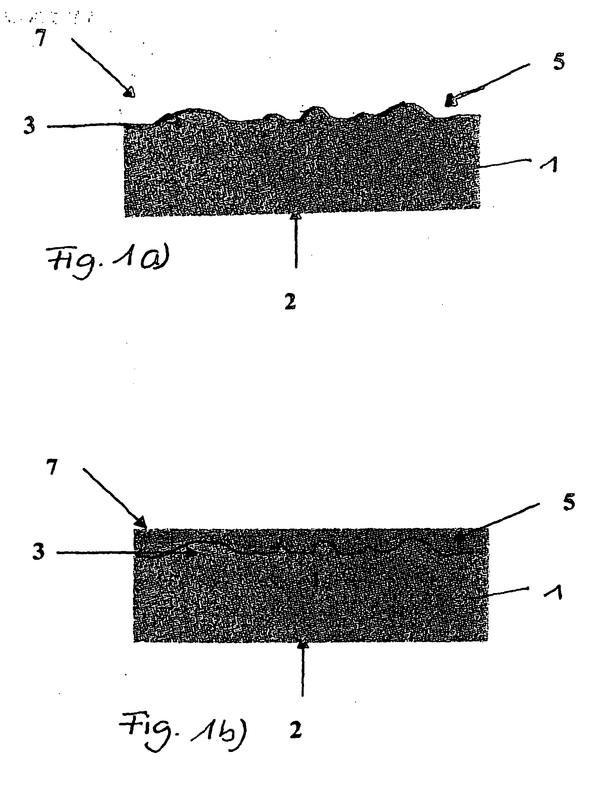

Im Folgenden wird der Ablauf einer Ausführungsform des erfindungsgemäßen Verfahrens anhand der Beschichtung einer Leichtmetallfelge erläutert. In Figur 1a ist eine schematische Teilquerschnittsansicht eines ersten Substrats 1 in Form eines Ausschnitts einer Aluminiumleichtmetallfelge 2 dargestellt. Die Unebenheiten 3 der Metalloberfläche sind zur besseren Veranschaulichung überzeichnet und schematisch dargestellt. Zunächst kann die Oberfläche des Substrats 1 in zwei Beizschritten entfettet werden. Dies dient dazu, Trennmittelrückstände aus dem Substratfertigungsprozeß, die sich auf der Oberfläche des Substrats 1 befinden können, zu entfernen. Insbesondere erfolgen diese beiden Entfettungsschritte derart, daß die Leichtmetallfelge 2 zunächst in ein, vorzugsweise alkalisches, Beizbad eingetaucht wird. In einem zweiten Beizschritt wird die Leichtmetallfelge 2 in einem etwa 60°C warmen, vorzugsweise alkalischen, Beizbad gebadet. Anschließend wird die Leichtmetallfelge 2 durch Spülen von den Beizrückständen befreit. Sodann kann die Oberfläche der Leichtmetallfelge 2 bzw. des Substrats 1 einem Dekapierschritt mit z.B. einem pH-sauren Mittel zur Entfernung einer vorhandenen Oxidationsschicht unterzogen werden. Nach dem Spülen mit Wasser und anschließend vorzugsweise mit vollentsalztem Wasser kann eine erste Grundierungsschicht 5 auf das Substrat 1 aufgebracht werden (s.a. Fig. 1b). Vorzugsweise erfolgt die Aufbringung der Grundierungsschicht in einem Naßlackbeschichtungsverfahren. Nach dem Aufbringen der Grundierung erfolgt vorzugsweise ein Wärmebehandlungs- bzw. Temperschritt, um eine Aushärtung bzw. ein Einbrennen der Grundierungsschicht 5 zu erreichen. Wie insbesondere Figur 1b zu entnehmen ist, entsteht durch die Grundierungsschicht 5 eine im Vergleich zur Oberfläche 3 des Substrats deutlich ebenere Oberfläche 7.

Optional kann auf die Grundierungsschicht 5 zwecks weiterer Oberflächeneinebnung eine weitere, in diesem Ausführungsbeispiel nicht dargestellte, zweite Grundierungsschicht aufgebracht werden. Diese dient insbesondere zur Erzeugung einer optimal glatten Oberfläche, einer optimalen Oberflächenhärte sowie auch dazu, eine nochmals optimierte Oberflächenspannung zu erreichen. Eine derart vorbereitete Leichtmetallfelge 2 kann den erfindungsgemäßen Verfahrensschritten zugeführt werden. Selbstverständlich kann auch jedes nicht vorbehandelte metallische Substrat dem erfindungsgemäßen Verfahren unterzogen werden, insbesondere im polierten und/oder geschliffenen Zustand.

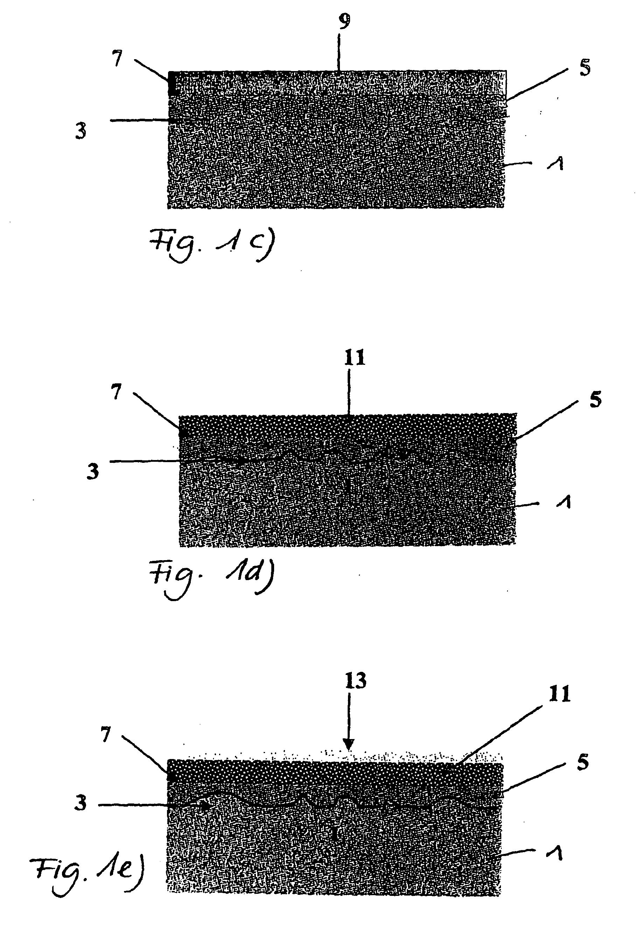

Hierfür wird, wie aus Figur 1c ersichtlich, vorzugsweise in einem Kathodenzerstäubungsprozeß, eine Metallschicht 9 aus z.B. Aluminium auf dem Substrat 1 bzw. der Grundierungsschicht 5 aufgebracht. Die durchschnittliche Dicke der Metallschicht kann hierbei z.B. etwa 50 bis 120 nm betragen.

In einem nachfolgenden Schritt kann optional eine Wärmebehandlung bzw. ein Tempern der Aluminiumschicht 9 vorgenommen werden, das vorzugsweise bei einer Temperatur von etwa 140°C durchgeführt wird.

Optional kann vorgesehen sein, daß ein Haftvermittler zwischen der Grundierungsschicht 5 und der Aluminiumschicht 9 insbesondere dadurch erzeugt wird, daß eine Plasmavorbehandlung in der Vakuumkammer, die zur Katodenzerstäubung dient, stattfindet. Durch diese Plasmavorbehandlung (Glimmen) in einer Edelgasatmosphäre (vorzugsweise umfassend Argon) kann ein sogenannter "base coat" aufgebracht werden. Eine derartige Erzeugung eines Haftvermittlers (nicht abgebildet) auf der Oberfläche der ersten Grundierungsschicht 5 bietet ebenfalls wirtschaftliche Vorteile, da in dem späteren Kathodenzerstäubungsprozeß der Druck in der Vakuumkammer in der Regel nicht mehr so niedrig gehalten werden muß, wodurch die Abpumpzeit der Vakuumkammer um circa 75% verkürzt werden kann, was wiederum die Durchlaufmengen erhöht. Dazu wird vorzugsweise ein Polymer, wie Hexamethyldisiloxan, in die Plasmakammer während der Erzeugung des Plasmas eingeführt.

Auf das Aufbringen der Aluminiumschicht 9 folgt dann bei der vorliegenden Ausführungsform, insbesondere unmittelbar im Anschluß, die Behandlung mit einem wäßrigen System, enthaltend Zirkonsäure (H₂ZrF₆) und/oder Zirkoniumsalze wie Zirkoniumcarbonat, beispielsweise Ammoniumzirkoniumcarbonat, und/oder Zirkoniumoxynitrat und gegebenenfalls Zirkoniumdioxid und/oder Fluorsäure. Das wäßrige System verfügt vorliegend über einen ph-Wert von etwa 2,5 und einen Leitwert kleiner 100 mS/cm. Die pH-Wert-Einstellung kann mit verdünnter Ammoniaklösung vorgenommen werden.

Bevorzugt wird für die Herstellung des wäßrigen Systems auf vollentsalztes Wasser zurückgegriffen. Vorteilhafterweise wird das mit der Aluminiumschicht versehene Substrat über geeignete Düsen mit dem beschriebenen wäßrigen System über eine Vielzahl an Hochdruckstrahlen, vorzugsweise mit einem Druck größer 0,5 bar, beaufschlagt. Durch bzw. während dieses Behandlungsprozesses werden die vorangehend beschriebenen Verbindungen des Zirkoniums in die Aluminiumschicht im wesentlichen über deren gesamte Dicke eingetragen. In dieser Schicht liegt das Zirkonium dann vorzugsweise oxidisch gebunden vor, beispielsweise als Zirkoniumdioxid. Anschließend erfolgt vorzugsweise eine Spülung der Oberfläche mit vollentsalztem Wasser. Das erhaltene Substrat wird sodann vorzugsweise einem Trocknungsschritt unterzogen. Wie Figur 1d zu entnehmen ist, wird durch die Anwendung des erfindungsgemäßen Verfahren auf dem Substrat 1 eine metallische Schutz- bzw. Kompositschicht 11 aus einem ersten Metall erhalten, in die z.B. Säuren, Salze und/oder insbesondere Oxide eines zweiten Metalls bzw. ein oxidisch gebundenes zweites Metall, vorzugsweise des Titans, Hafniums und insbesondere des Zirkoniums, vorzugsweise im wesentlichen gleichförmig und über die gesamte Dicke der Metallschicht verteilt, eingelagert sind.

Um einer Beschädigung der metallischen Schutzschicht 11 durch mechanische Einflüsse entgegenzuwirken, wird vorzugsweise abschließend auf diese Schicht eine transparente Decklackschicht 13 aufgebracht. Dabei kann es sich insbesondere um einen Pulverklarlack umfassend Acryl, Polyester oder ein Mischpulver handeln, oder es können auch Naßlacke aufgebracht werden (s.a. Figur 1e).

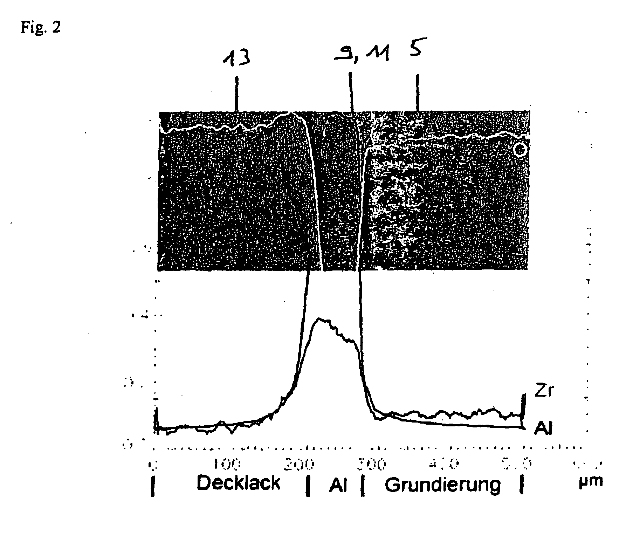

Figur 2 stellt eine semiquantitative Darstellung der lateralen Verteilung der Elemente Zr, Al und O durch Auswertung eines EDX-Elementmaps dar (EDX = energiedispersive Röntgenmikroanalyse). Dieses Ergebnis wurde anhand energiedispersiver Röntgenmikroanalyse gekoppelt mit der ESEM-Technik (Environmental Scanning Electron Microscopy; Rasterelektronenmikroskopie) erhalten (Anregungsspannung 10 keV). Die Abbildung erfolgte mit Sekundärelektronen (SE-Topographiekontrast) oder mit Rückstreuelektronen (BSE-Materialkontrast). Für die EDX-Aufnahme wurde von einem beschichteten Substrat (beispielsweise wie in Figur 1e) wiedergegeben), enthaltend eine Grundierungsschicht, die metallische Schutz- bzw. Kompositschicht und die Deckschicht, ein Mikrotom-Schrägschnitt unter flachem Winkel angefertigt (Streckungsfaktor ca. 400). Zwischen der Decklackschicht 13 und der Grundierungsschicht 5 ist die metallische Schutz- bzw. Kompositschicht 11 deutlich zu erkennen. Neben Aluminium als Hauptkomponente findet sich in der Kompositschicht Zirkonium (in Form von oxidisch gebundenem Zirkonium, wie nachfolgend noch gezeigt wird) im wesentlichen gleichmäßig über die gesamte Dicke der Aluminiumschicht 9 verteilt.

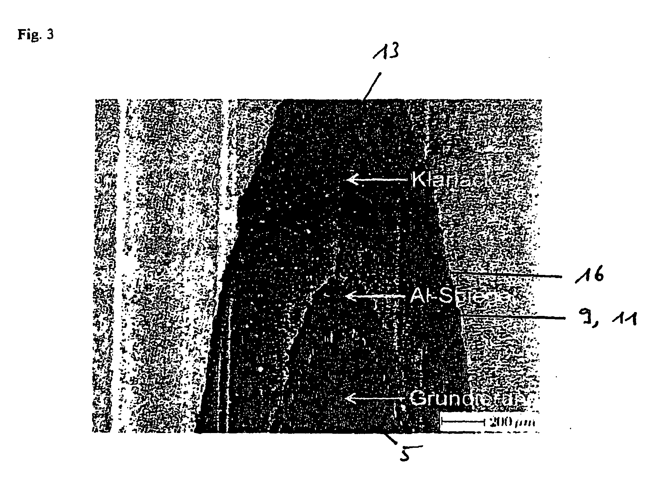

Dieses Ergebnis wird anhand einer Linescan-Untersuchung über die Oberfläche eines Mikrotom-Rumpfschnittes, wie in Figur 3 wiedergegeben, bestätigt. Der Linescan 16, entlang dem an diskreten, aufeinander folgenden Meßpunkten TOF-SIMS-Messungen vorgenommen wurden, ist in Fig. 3 schematisch dargestellt

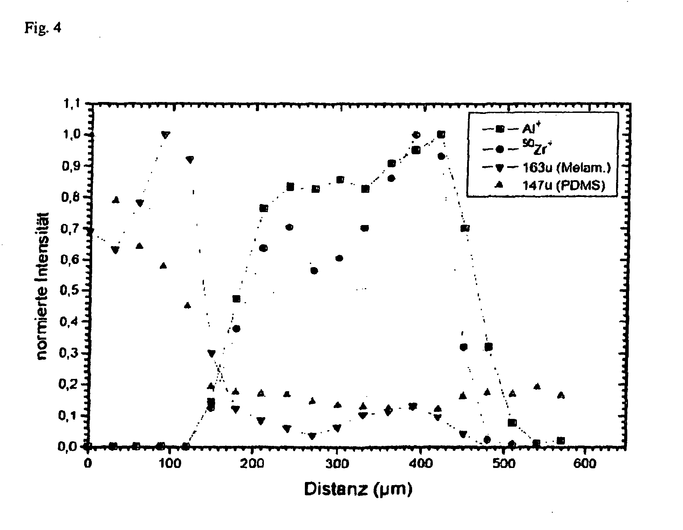

Figur 4 zeigt die mittels TOF-SIMS-Untersuchungen erhaltenen normierten Intensitäten der Signallinien ausgewählter Elemente bzw. Verbindungen entlang des Linescans 16 gemäß Figur 3. Normiert wurde auf die Summe der Intensitäten ausgewählter Kohlenwasserstoffsignale. Insgesamt wurde über eine Linescan-Länge von etwa 600 µm an 20 Meßpunkten die Intensität charakteristischer Signale massenspektroskopisch untersucht. Der Linescan erstreckte sich hierbei über die gesamte Breite der metallischen Kompositschicht und deckte zusätzlich die sich an die Schutzschicht anschließenden Abschnitte der Schutzlackschicht 13 und der Grundierungsschicht 5 ab. Bei TOF-SIMS handelt es sich um ein Verfahren der Flugzeit-Sekundärionen-Massenspektrometrie zum hochempfindlichen Nachweis von Elementen und anorganischen sowie organischen Verbindungen an Materialoberflächen. Hiermit sind ortsaufgelöste Analysen im µm- und nm-Bereich möglich. Wie Figur 4 deutlich zu entnehmen ist, werden für die metallische Kompositschicht 11 neben Aluminiumsignalen eindeutig Zirkoniumsignale in hoher Intensität gefunden, und zwar verteilt über die gesamte Dicke der metallischen Schutzschicht. Die darüber hinaus in der metallischen Schutzschicht detektierten Signale für Melamin und PDMS sind der Schutzlackschicht zuzurechnen und gehen auf die Herstellung des verwendeten Mikrotomschnitts zurück. Um eine ausreichende Meßfläche bzw. -strecke zur Verfügung zu haben, mußte die untersuchte Probe schräg angeschnitten werden. Auf diese Weise gelang es, die sich über die nur etwa 100 nm dicke metallische Kompositschicht 11 erstreckende Meßstrecke auf etwa 400 µm auszudehnen. Bei diesem Anschneidevorgang kann regelmäßig nie vollständig verhindert werden, daß auch Material anderer Schichten in benachbarte Schichten eingetragen bzw. verschmiert wird.

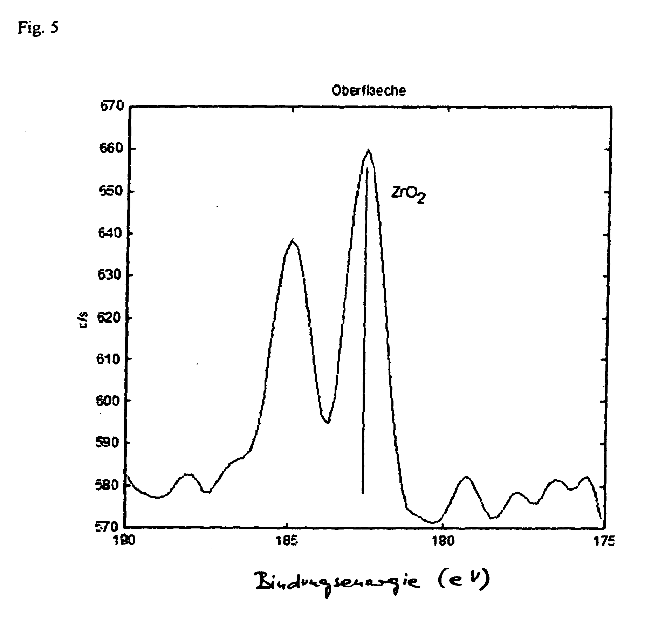

Figur 5 gibt einen XPS-Spektrum wieder, aufgenommen im Bereich der metallischen Kompositschicht 11 eines Substrats 1 gemäß Figur 1e), bei dem die Deckschicht zuvor entfernt worden ist. Die X-Ray Excited Photoelectron Spectroscopy (XPS) erlaubt bei Festkörpern neben der quantitativen Identifizierung der in unmittelbarer Oberflächennähe vorliegenden Elemente ebenfalls die Ermittlung von Bindungszuständen. Das für die metallische Kompositschicht aufgenommene XPS-Spektrum zeigt im Bereich von 180 bis 186 eV ein für die Spezies Zirkoniumdioxid charakteristisches Dublettsignal. Demgemäß liegt in der metallischen Schutzschicht des hier untersuchten Substrats oxidisch gebundenes Zirkonium vornehmlich in der Form des Zirkoniumdioxids vor. Auch die XPS-Tiefenprofilanalyse der Kompositschicht 11 bestätigte, daß Zirkonium (wie vorangehend gezeigt werden konnte, oxidisch gebunden) über im wesentlichen die gesamte Breite dieser Schicht verteilt vorliegt.

Die nach dem erfindungsgemäßen Verfahren erhaltene Leichtmetallfelge erfüllt sowohl die Anforderungen, die von der Automobilindustrie an die Beständigkeit der Beschichtung gestellt werden, als auch die Anforderungen, die von dem Gesetzgeber zur Zulassung des Beschichtungssystems für die Behandlung von Autofelgen gestellt werden. Insbesondere hat eine gemäß dem zuvor beschriebenen erfindungsgemäßen Verfahren behandelte Leichtmetallfelge den Gitterschnittest nach DIN EN ISO 2409, eine Salzsprühnebelprüfung (Cass-Test) nach DIN EN ISO 50021 (keine Veränderung der Oberfläche nach 240 h) sowie einen Steinschlagtest nach VDA 421412 ohne irgendwelche Probleme bestanden. Des weiteren führt die zuvor beschriebene Beschichtung der Leichtmetallfelge zu einer optisch qualitativ hochwertigen Beschichtung derart, daß mit einem vergleichsweise geringen Aufwand eine sehr widerstandsfähige Oberfläche mit einer Chrom-Optik erzeugt wird.

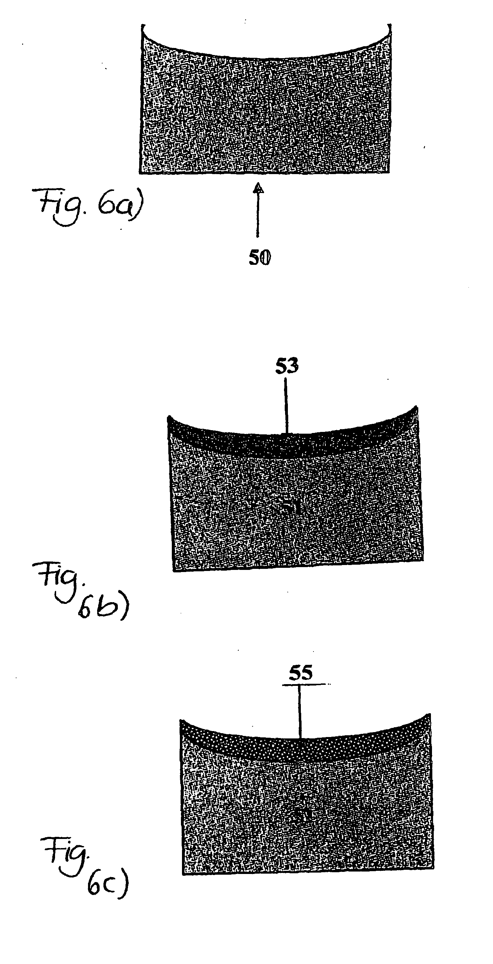

In Figur 6 a) ist ein Substrat in Form eines Kunststoffspritzteils 51, welches z.B. als Reflektor für einen Scheinwerfer dienen kann, dargestellt. Durch das erfindungsgemäße Verfahren kann auf der Oberfläche des Kunststoffspritzteils 51 unmittelbar eine Spiegelfläche erzeugt werden, die ebenfalls sehr gute Korrosionseigenschaften, insbesondere sehr gute Langzeitstabilitätseigenschaften, auch in feuchten Umgebungen und ohne das Aufbringen einer zusätzlichen Schutzlackschicht, aufweist. Vor der Durchführung des erfindungsgemäßen Verfahrens kann das Kunststoffspritzteil 51 optional gereinigt werden, um gegebenenfalls vorhandene Trennmittel oder Staubreste zu entfernen, beispielsweise durch Spülen mit Wasser. Auch kann vorgesehen sein, daß auf die Oberfläche des Kunststoffspritzteils 51 zunächst eine Grundierungsschicht aufgebracht wird, wobei vorzugsweise Naßlacke bzw. Naßlackgrundierungen eingesetzt werden.

Gemäß Figur 6 b) wird nach dem erfindungsgemäßen Verfahren in einem Kathodenzerstäubungsprozeß eine Aluminiumschicht 53 auf das Kunststoffsubstrat aufgebracht. Die Dicke dieser Schicht kann beispielsweise 55 bis 120 nm betragen. Gleichfalls wird eine optisch qualitativ hochwertige Oberfläche auf dem Kunststoffspritzteil 51 erzeugt, die sehr gute Reflexionseigenschaften aufweist, so daß der Reflektor über sehr gute optische Eigenschaften verfügt. Je nach verwendetem Kunststoff für das Kunststoffspritzteil 51 kann nach Aufbringen der Aluminiumschicht 53 ein Wärmebehandlungsschritt vorgenommen werden. In einem sich vorzugsweise unmittelbar anschließenden Verfahrensschritt wird das Substrat, wie bereits vorangehend für die Metallschicht 2 beschrieben, mit einem wäßrigen System, enthaltend z.B. eine Säure und/oder ein Salz eines zweiten Metalls, z.B. Zirkoniumsäure (H₂ZrF₆) und/oder Ammoniumzirkoniumcarbonat, und gegebenenfalls Zirkoniumdioxid und/oder Flußsäure beaufschlagt. Auch bei Substraten aus Kunststoff kann das wäßrige System mit Druck über Düsen auf die Metallschicht aufgebracht werden, beispielsweise mit Drücken größer 0,5 bar, so daß wieder ein Eintrag der genannten Verbindungen des zweiten Metalls in die Aluminiumschicht stattfindet (s.a. Fig. 6c). Somit liefert das erfindungsgemäße Verfahren einen Reflektor 50, der sowohl sehr widerstandsfähig und korrosionsbeständig ist als auch sehr gute optische Eigenschaften aufweist. Anders als bei dem aus dem Stand der Technik bekannten Reflektoren aus Kunststoff bedarf es nicht mehr einer zusätzlichen Decklackschicht auf der metallischen Schutzschicht.

Die in der vorstehenden Beschreibung, in den Zeichnungen sowie in den Ansprüchen offenbarten Merkmale der Erfindung können sowohl einzeln, als auch in jeder beliebigen Kombination für die Verwirklichung der Erfindung in ihren verschiedenen Ausführungsformen wesentlich sein.

### Bezugszeichenliste

- 1: Substrat
- 2: Leichtmetallfelge
- 3: Oberflächenunebenheiten
- 5: Grundierungsschicht
- 7: Oberfläche
- 9: Aluminiumschicht
- 11: metallische Schutz- bzw. Kompositschicht
- 13: Decklackschicht
- 16: Linescan
- 50: Reflektor
- 51: Kunststoffspritzteil
- 53: Aluminiumschicht
- 55: metallische Schutz- bzw. Kompositschicht

## Patentansprüche

1. Verfahren zur Herstellung eines mindestens bereichsweise korrosionsgeschützten und insbesondere glänzenden metallischen oder nicht-metallischen Substrats, umfassend, in dieser Reihenfolge,
a) Zurverfügungstellung eines Substrats mit mindestens einer zumindest bereichsweise beschichtbaren Oberfläche,
c) Aufbringen mindestens einer metallischen Kompositschutzschicht mit einer Dicke im Bereich von 20 nm bis 120 nm, enthaltend als erstes Metall Aluminium, Blei, Vanadium, Mangan, Magnesium, Eisen, Kobalt, Nickel, Kupfer, Titan, oder Zink oder als erste Metalllegierung Messing, Bronze, Edelstahl oder eine Magnesium-, Titan- oder Aluminiumlegierung und darin verteilt vorliegend mindestens ein Oxid, Doppeloxid, Oxid-Hydrat oder Oxyhalogenid eines zweiten Metalls, ausgewählt aus der Gruppe, bestehend aus Zirkonium, Titan und Hafnium, wobei der Verfahrensschritt c) die Teilschritte umfasst
i) Aufbringen einer Metallschicht aus dem ersten Metall oder der ersten Metalllegierung mittels Physical Vapor Deposition (PVD)-Beschichtung, Aufdampfen mittels eines Elektronenstrahl-Verdampfers, Aufdampfen mittels eines Widerstandsverdampfers, Induktionsverdampfung, ARC-Verdampfung und/oder Kathodenzerstäubung (Sputter-Beschichtung), jeweils in einem Hochvakuum, auf der beschichtbaren Oberfläche des Substrats und
ii) Eintragen mindestens eines Oxids, Doppeloxids, Oxid-Hydrats oder Oxyhalogenids des zweiten Metalls in die Metallschicht durch Behandeln der Metallschicht mit einem wässrigen System, enthaltend mindestens eine Säure, ein Oxid, Doppeloxid, Oxid-Hydrat, Oxyhalogenid und/oder Salz des zweiten Metalls,
wobei man die Metallschicht mit dem wässrigen System unter Druck beaufschlagt und wobei man nach dem Aufbringen einer Metallschicht gemäß Schritt c) i) und vor dem Behandlungsschritt c) ii) das Substrat einem Spülschritt mit vollentsalztem Wasser (VE-Wasser) unterzieht.

2. Verfahren nach Anspruch 1, **dadurch gekennzeichnet, dass**
das wässrige System einen pH-Wert im Bereich von 1,5 bis 6,5 aufweist.

3. Verfahren nach Anspruch 1 oder 2, **dadurch gekennzeichnet, dass**
das metallische Substrat Metalle, Metalllegierungen oder Edelmetalle, insbesondere Magnesium, Titan oder Aluminium oder eine Magnesium-, Titan- oder Aluminiumlegierung, und dass das nicht-metallische Substrat Glas, Keramik, Carbonmaterialien oder Kunststoff umfasst.

4. Verfahren nach einem der vorangehenden Ansprüche, ferner umfassend zwischen den Schritten a) und c) den Schritt:
b) Aufbringen zumindest einer ersten und gegebenenfalls einer zweiten Grundierungsschicht auf das Metall- oder Kunststoffsubstrat und/oder Schleifen und/oder Polieren der Substratoberfläche.

5. Verfahren nach einem der vorangehenden Ansprüche, **dadurch gekennzeichnet, dass**
das erste Metall Magnesium, Titan oder Aluminium oder eine Magnesium-, Titan- oder Aluminiumlegierung umfasst.

6. Verfahren nach Anspruch 5, **dadurch gekennzeichnet, dass**
das erste Metall Aluminium oder dass die erste Metalllegierung eine Aluminiumlegierung umfasst.

7. Verfahren nach einem der vorangehenden Ansprüche, **dadurch gekennzeichnet, dass**
die Reinheit des ersten Metalls mindestens 80 Gew.%, insbesondere mehr als 90 Gew.-%, beträgt.

8. Verfahren nach einem der vorangehenden Ansprüche, **dadurch gekennzeichnet, dass**
die Dicke der gemäß Verfahrensschritt c) erhaltenen Schutzschicht im Bereich von 50 nm bis 120 nm und insbesondere kleiner 100 nm liegt.

9. Verfahren nach einem der vorangehenden Ansprüche, **dadurch gekennzeichnet, dass**
nach Schritt c) das Substrat einem Spülschritt mit vollentsalztem Wasser (VE-Wasser) unterzogen wird.

10. Verfahren nach einem der vorangehendem Ansprüche, **dadurch gekennzeichnet, dass**
die Oxide Zirkoniumoxide, Titanoxide oder Hafniumoxide, die Oxyfluoride Zirkoniumoxyfluoride, Titanoxyfluoride oder Hafniumoxyfluoride, die Säuren Fluorzirkonsäure, Fluortitansäure oder Fluorhafniumsäure und die Salze Fluorzirkonate, Fluortitanate oder Fluorhafniate darstellen.

11. Verfahren nach einem der vorangehenden Ansprüche, **dadurch gekennzeichnet, dass**
man die Metallschicht mit dem wässrigen System unter Druck in Form von Flüssigkeitsstrahlen beaufschlagt.

12. Verfahren nach einem der vorangehenden Ansprüche, **dadurch gekennzeichnet, dass**
man die Metallschicht mit dem wässrigen System mit einem Druck im Bereich von 0,2 bis 15 bar, gemessen auf der Oberfläche der Metallschicht, beaufschlagt.

13. Verfahren nach einem der vorangehenden Ansprüche, **dadurch gekennzeichnet, dass**
sich an den Verfahrensschritt c) ein Trocknungsschritt zum Trocknen der Oberfläche an.

14. Verfahren nach einem der vorangehenden Ansprüche, **dadurch gekennzeichnet, dass**
das zum Spülen eingesetzte Wasser über einen Leitwert kleiner 60 mS/cm, insbesondere kleiner 50 mS/cm, verfügt.

15. Verfahren nach einem der vorangehenden Ansprüche, **dadurch gekennzeichnet, dass**
nach dem Schritt c) zumindest eine Decklackschicht und/oder einer Lasur aufgebracht wird.

## Claims

1. A method for the manufacture of an at least partially corrosion protected and in particular shiny metallic or non-metallic substrate, comprising, in the following order:
a) the provision of a substrate with at least one at least partially coatable surface,
c) the application of at least one metallic composite protective layer with a thickness in the range of 20 nm to 120 nm, containing as a first metal aluminium, lead, vanadium, manganese, magnesium, iron, cobalt, nickel, copper, titanium or zinc, or as a first metal alloy brass, bronze, stainless steel or a magnesium, titanium or aluminium alloy, and distributed therein, at least one oxide, double oxide, oxide hydrate or oxyhalogenide of a second metal selected from the group consisting of zirconium, titanium and hafnium, wherein processing stage c) comprises the following sub-stages:
i) the application of a metal layer from the first metal or the first metal alloy by means of Physical Vapour Deposition (PVD) coating, vaporisation by means of an electron stream vaporiser, vaporisation using a resistance vaporiser, induction vaporisation, ARC vaporisation and/or cathode spraying (sputter coating), in each case in a high vacuum, onto the coated surface of the substrate, and
ii) the incorporation of at least one oxide, double oxide, oxide hydrate or oxyhalogenide of the second metal into the metal layer by treating the metal layer with an aqueous system containing at least one acid, one oxide, double oxide, oxide hydrate, oxyhalogenide and/or salt of the second metal, wherein the metal layer is treated with the aqueous system under pressure and wherein after the application of a metal layer according to stage c) i), and prior to the treatment stage c) ii), the substrate is subjected to a rinsing stage with fully de-salinated water (FD water).

2. A method according to claim 1, **characterised in that**
the aqueous system has a pH value in the range of 1.5 to 6.5.

3. A method according to either of claims 1 or 2, **characterised in that**
the metallic substrate comprises metals, metal alloys or precious metals, in particular magnesium, titanium or aluminium, or a magnesium, titanium or aluminium alloy, and that the non-metallic substrate comprises glass, ceramic, carbon materials, or plastic.

4. A method according to any one of the preceding claims, furthermore comprising between stages a) and c) the following stage:
b) the application of a first and, if appropriate, a second base coat layer onto the metal or plastic substrate, and/or grinding and/or polishing the substrate surface.

5. A method according to any one of the preceding claims, **characterised in that**
the first metal comprises magnesium, titanium or aluminium or a magnesium, titanium or aluminium alloy.

6. A method according to claim 5, **characterised in that**
the first metal comprises aluminium, or that the first metal alloy comprises an aluminium alloy.

7. A method according to any one of the preceding claims, **characterised in that**
the purity of the first metal is at least 80% by weight, in particular over 90% by weight.

8. A method according to any one of the preceding claims, **characterised in that**
the thickness of the protective layer obtained according to method stage c) lies in the range of 50 mn to 120 nm, and is in particular less than 100 nm.

9. A method according to any one of the preceding claims, **characterised in that**
after stage c), the substrate is subjected to a rinsing stage with fully de-salinated water (FD water).

10. A method according to any one of the preceding claims, **characterised in that**
the oxides are zirconium oxides, titanium oxides or hafnium oxides, the oxyfluorides are zirconium oxyfluorides, titanium oxyfluorides or hafnium oxyfluorides, the acids are fluorozirconic acid, fluorotitanic acid or fluorohafnic acid, and the salts are fluorozirconates, fluorotitanates or fluorohafniates.

11. A method according to any one of the preceding claims, **characterised in that**
the metallic layer is treated with the aqueous system under pressure in the form of fluid jets.

12. A method according to any one of the preceding claims, **characterised in that**
the metallic layer is treated with the aqueous system with a pressure in the range of 0.2 to 15 bar, measured on the surface of the metal layer.

13. A method according to any one of the preceding claims, **characterised in that**
a drying stage is added to method stage c) in order to dry the surface.

14. A method according to any one of the preceding claims, **characterised in that**
the water used for rinsing purposes has a conductivity of less than 60 mS/cm, in particular less than 50 mS/cm.

15. A method according to any one of the preceding claims, **characterised in that**
after stage c), at least one cover lacquer layer and/or a glaze is applied.

## Revendications

1. Procédé de fabrication d'un substrat métallique ou non métallique protégé contre la corrosion au moins par secteur et en particulier brillant, comprenant, dans cet ordre, les étapes consistant à
a) mettre à disposition un substrat ayant au moins une surface pouvant être revêtue au moins par secteur,
c) appliquer au moins une couche de protection composite métallique ayant une épaisseur dans la plage de 20 nanomètres à 120 nanomètres, contenant, en tant que premier métal, de l'aluminium, du plomb, du vanadium, du manganèse, du magnésium, du fer, du cobalt, du nickel, du cuivre, du titane, ou du zinc ou, en tant que premier alliage métallique, du laiton, du bronze, de l'acier inoxydable ou un alliage de magnésium, du titane ou d'aluminium et, présent de manière répartie à l'intérieur, au moins un oxyde, un oxyde double, un hydrate d'oxyde ou un oxyhalogénure d'un deuxième métal, sélectionné parmi le groupe constitué du zirconium, du titane et de l'hafnium, l'étape de procédé c) comprenant les étapes partielles consistant à
i) appliquer une couche métallique issue du premier métal ou du premier alliage métallique grâce à un revêtement par dépôt physique en phase gazeuse (PVD), une métallisation par évaporation grâce à un évaporateur à faisceau d'électrons, une métallisation par évaporation grâce à un évaporateur à résistance, une évaporation par induction, une évaporation ARC et/ou une pulvérisation cathodique (revêtement par dépôt par pulvérisation), respectivement sous vide élevé, sur la surface pouvant être revêtue du substrat et
ii) charger au moins un oxyde, un oxyde double, un hydrate d'oxyde ou un oxyhalogénure du deuxième métal dans la couche métallique grâce au traitement de la couche métallique avec un système aqueux, contenant au moins un acide, un oxyde, un oxyde double, un hydrate d'oxyde, un oxyhalogénure et/ou un sel du deuxième métal,
la couche métallique étant alimentée sous pression avec le système aqueux et
le substrat étant soumis à une étape de rinçage avec de l'eau déminéralisée (eau complètement déminéralisée) après l'application d'une couche métallique selon l'étape c) i) et avant l'étape de traitement c) ii).

2. Procédé selon la revendication 1, **caractérisé en ce que** le système aqueux présente une valeur de pH dans la plage de 1,5 à 6,5.

3. Procédé selon la revendication 1 ou 2, **caractérisé en ce que** le substrat métallique comprend des métaux, des alliages métalliques ou des métaux précieux, en particulier du magnésium, du titane ou de l'aluminium ou un alliage de magnésium, de titane ou d'aluminium, et le substrat non métallique comprend du verre, de la céramique, des matériaux en carbone, ou du plastique.

4. Procédé selon l'une quelconque des revendications précédentes, comprenant en outre, entre les étapes a) et c), l'étape consistant à :
b) appliquer au moins une première et éventuellement une deuxième couche d'apprêt sur le substrat métallique ou le substrat de plastique et/ou meuler et/ou polir la surface de substrat.

5. Procédé selon l'une quelconque des revendications précédentes, **caractérisé en ce que** le premier métal comprend du magnésium, du titane ou de l'aluminium ou un alliage de magnésium, de titane ou d'aluminium.

6. Procédé selon la revendication 5, **caractérisé en ce que** le premier métal comprend de l'aluminium ou le premier alliage métallique comprend un alliage d'aluminium.

7. Procédé selon l'une quelconque des revendications précédentes, **caractérisé en ce que** la pureté du premier métal est d'au moins 80 % en poids, en particulier supérieure à 90 % en poids.

8. Procédé selon l'une quelconque des revendications précédentes, **caractérisé en ce que** l'épaisseur de la couche de protection obtenue selon l'étape de procédé c) se situe dans la plage de 50 nm à 120 nm et est en particulier inférieure à 100 nm.

9. Procédé selon l'une quelconque des revendications précédentes, **caractérisé en ce que** le substrat est soumis à une étape de rinçage avec de l'eau déminéralisée (eau complètement déminéralisée) après l'étape c).

10. Procédé selon l'une quelconque des revendications précédentes, **caractérisé en ce que** les oxydes représentent des oxydes de zirconium, des oxydes de titane ou des oxydes d'hafnium, les oxyfluorures représentent des oxyfluorures de zirconium, des oxyfluorures de titane ou des oxyfluorures d'hafnium, les acides représentent des acides fluorozirconiques, des acides fluorotitaniques ou des acides fluorohafniques, et les sels représentent des zirconates de fluor, des titanates de fluor ou des hafniates de fluor.

11. Procédé selon l'une quelconque des revendications précédentes, **caractérisé en ce que** la couche métallique est alimentée avec le système aqueux sous pression sous la forme de jets de liquide.

12. Procédé selon l'une quelconque des revendications précédentes, **caractérisé en ce que** la couche métallique est alimentée avec le système aqueux à une pression dans la plage de 0,2 à 15 bars, mesurée sur la surface de la couche métallique.

13. Procédé selon l'une quelconque des revendications précédentes, **caractérisé en ce qu'**une étape de séchage en vue du séchage de la surface a lieu au niveau de l'étape de procédé c).

14. Procédé selon l'une quelconque des revendications précédentes, **caractérisé en ce que** l'eau utilisée pour le rinçage est fournie avec une valeur d'acheminement inférieure à 60 mS/cm, en particulier inférieure à 50 mS/cm.

15. Procédé selon l'une quelconque des revendications précédentes, **caractérisé en ce qu'**au moins une couche de peinture de couverture et/ou une lasure est appliquée après l'étape c).
